(19) Europäisches Patentamt / European Patent Office / Office européen des brevets

(11) **EP 3 266 043 B1**

(12) **EUROPEAN PATENT SPECIFICATION**

(45) Date of publication and mention
of the grant of the patent:
**08.05.2024 Bulletin 2024/19**

(21) Application number: **16761926.1**

(22) Date of filing: **03.03.2016**

(51) International Patent Classification (IPC):
**H01L 23/552** (2006.01)   **H01L 23/24** (2006.01)

(52) Cooperative Patent Classification (CPC):
(C-Sets available)
**B05B 15/20; H01L 23/24; H01L 23/552;**
**H05K 1/0218; H05K 3/284;** H01L 23/49838;
H01L 24/13; H01L 24/16; H01L 2224/131;
H01L 2224/16227; H01L 2924/181;
H01L 2924/19041; H01L 2924/19042;
H01L 2924/19043; H01L 2924/19105;   (Cont.)

(86) International application number:
**PCT/KR2016/002111**

(87) International publication number:
**WO 2016/144039 (15.09.2016 Gazette 2016/37)**

(54) **ELECTROMAGNETICALLY SHIELDED SEMICONDUCTOR CHIP PACKAGE AND MANUFACTURING METHOD THEREOF**

ELEKTROMAGNETISCH ABGESCHIRMTES HALBLEITERSCHALTUNGSELEMENTGEHÄUSE UND HERSTELLUNGSVERFAHREN DAFÜR

BOÎTIER D'ÉLÉMENT DE CIRCUIT SEMI-CONDUCTEUR À BLINDAGE ÉLECTROMAGNÉTIQUE ET SON PROCÉDÉ DE FABRICATION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **06.03.2015 US 201562129245 P**
**19.11.2015 KR 20150162318**

(43) Date of publication of application:
**10.01.2018 Bulletin 2018/02**

(73) Proprietor: **Samsung Electronics Co., Ltd.**
**Suwon-si, Gyeonggi-do 16677 (KR)**

(72) Inventors:
• **KUK, Keon**
**Yongin-si**
**Gyeonggi-do 16822 (KR)**
• **KO, Young-dae**
**Suwon-si**
**Gyeonggi-do 16509 (KR)**
• **BEAK, O-hyun**
**Seoul 06602 (KR)**
• **HAN, Eun-bong**
**Suwon-si**
**Gyeonggi-do 16547 (KR)**
• **KIM, Hyeon-hyang**
**Seoul 06781 (KR)**
• **JUNG, Yeon-kyoung**
**Seoul 06630 (KR)**
• **MUN, Il-ju**
**Suwon-si**
**Gyeonggi-do 16697 (KR)**

(74) Representative: **Lorenz, Sönke**
**Gulde & Partner**
**Patent- und Rechtsanwaltskanzlei mbB**
**Wallstraße 58/59**
**10179 Berlin (DE)**

(56) References cited:
WO-A1-00/13233          US-A- 5 583 378
US-A1- 2007 030 661     US-A1- 2007 176 281
US-A1- 2012 104 571     US-A1- 2014 198 459
US-A1- 2014 271 961     US-B2- 7 482 686

(52) Cooperative Patent Classification (CPC): (Cont.)
 H01L 2924/3025; H05K 2201/0715;
 H05K 2203/0126; H05K 2203/1316

 C-Sets
 H01L 2224/131, H01L 2924/014, H01L 2924/00014;
 H01L 2924/181, H01L 2924/00012

## Description

## Technical Field

Apparatuses and methods consistent with exemplary embodiments relate to a circuit element package and a manufacturing method thereof, to a circuit element package having electromagnetic shielding members that protect a semiconductor chip included in the package and shields electromagnetic waves, a manufacturing method thereof.

## Background Art

Recently, demand for portable devices has been abruptly increased in the electronic product market, and due to this, miniaturization and reduction of weight of electronic components that are mounted on such electronic products are continuously occurring. To realize the miniaturization and reduction of weight of electronic components, not only a technology that can reduce individual sizes of the mounted components but also a semiconductor package technology that can integrate individual elements into one package are used. A semiconductor package that processes a high-frequency signal uses not only miniaturization but also various electromagnetic shielding structures for prominently implementing electromagnetic interference or electromagnetic tolerance characteristics.

For this, an electromagnetic shielding structure in the related art that is applied to a semiconductor package is configured so that a shield can of a press-processed metal material is provided to cover elements (e.g., semiconductor chip or passive elements) mounted on a printed circuit board, and the shield can is fixed onto the printed circuit board through soldering with ground terminals of the printed circuit board

According to the electromagnetic shielding structure in the related art, however, the inner surface of the metal shield can is upwardly spaced apart from upper ends of the elements for a predetermined distance so that a predetermined air gap is provided between the elements and the inner surface of a cover to prevent a short circuit between the inner surface of the metal shield can and the elements Due to such an air gap, the overall height of the electromagnetic shielding structure is increased. Further, the thermal insulation effect that occurs due to the air gap may be an obstacle to the dissipation of heat that is generated from the elements out of the shield can, and heat dissipation holes are formed for ventilation on the shield can to overcome the obstacle

However, such heat dissipation holes may cause the electromagnetic shielding performance to deteriorate.

US 7482686A discloses an IC package.

WO00/13233A1 discloses an IC package comprising a substrate including a common voltage plane and a mounting region, the IC device mounted to the mounting region and an electrically conductive dam structure disposed on a surface of the substrate circumscribing a perimeter of the mounting region and a pocket is defined between the dam structure and the mounting region which is filled with an electrically insulating encapsulant.

US 5583378 discloses a circuit element package comprising: at least one circuit element mounted on a printed circuit board; an insulating layer covering the at least one circuit element and an upper surface of the printed circuit board; and an electromagnetic shielding layer covering the insulating layer, a first layer covering a side surface of the insulating layer, and a electromagnetic shielding layer covering an upper surface of the insulating layer, the circuit element package further comprises an edge bridge, disposed between the first layer and the electromagnetic shielding layer to cover a boundary between the first layer and the insulating layer and the periphery thereof and on the upper surface of the first layer , wherein the electromagnetic shielding layer is further covering an upper surface of the edge bridge and wherein the edge bridge is connecting the first layer and the electromagnetic shielding layer; and the circuit element is a semiconductor chip connected to the printed circuit board by connection terminals and respective connection pads on an upper surface of the printed circuit board.

## Disclosure of Invention

## Technical Problem

One or more exemplary embodiments provide a circuit element package for a semiconductor chip having electromagnetic shielding characteristics with a minimum thickness, a manufacturing method thereof, and a manufacturing apparatus thereof.

## Solution to Problem

The invention is defined by the claims,

A first aspect of the present disclosure is a circuit element package comprising: at least one circuit element mounted on a printed circuit board, an insulating layer covering the at least one circuit element and an upper surface of the printed circuit board; and an electromagnetic shielding layer covering the insulating layer, wherein the electromagnetic shielding layer includes a first electromagnetic shielding layer covering a side surface of the insulating layer, and a second electromagnetic shielding layer covering an upper surface of the insulating layer, the circuit element package further comprises an edge bridge, disposed between the first electromagnetic shielding layer and the second electromagnetic shielding layer to cover a boundary between the first electromagnetic shielding layer and the insulating layer and the periphery thereof and on a peripheral portion of the upper surface of the insulating layer and laminated on the upper surface of the first electromagnetic shielding layer, wherein the second electromagnetic shielding layer is further covering an upper surface of the edge bridge and wherein the edge bridge is electrically connecting the first electromagnetic shielding layer and the second electromagnetic shielding layer; and the circuit element is a semiconductor chip connected to the printed circuit board by connection terminals and respective connection pads on an upper surface of the printed circuit board.

A second object of the present invention is a method for manufacturing a circuit element package, comprising: mounting a circuit element on a printed circuit board wherein the circuit element is a semiconductor chip connected to the printed circuit board by connection terminals and respective connection pads on an upper surface of the printed circuit board; forming a first electromagnetic shielding layer on the printed circuit board to form a dam; forming an insulating layer on the inside of the first electromagnetic shielding layer to cover the circuit element and the upper surface of the printed circuit board; and wherein the insulating layer is injected into the first electromagnetic shielding layer and then cured after the first electromagnetic shielding layer is formed, forming an edge bridge to cover a boundary between the first electromagnetic shielding layer and the insulating layer and the periphery thereof on an upper surface of the first electromagnetic shielding layer and a peripheral portion of an upper surface of the insulating layer; and forming a second electromagnetic shielding layer to cover the upper surface of the insulating layer and an upper surface of the edge bridge, wherein the first electromagnetic shielding layer is covering a side surface of the insulating layer, wherein the edge bridge is electrically connecting the first electromagnetic shielding layer and the second electromagnetic shielding layer to each other.

Preferably, at the time of the injecting of the insulating layer, the first electromagnetic shielding layer comprises an electromagnetic shielding material having a viscosity higher than a viscosity of the insulating layer.

**Brief Description of Drawings**

The above and/or other aspects will be more apparent by describing exemplary embodiments with reference to the accompanying drawings, in which:

FIG. 1 is a cross-sectional view illustrating a claimed circuit element package according to an exemplary embodiment which falls within the scope of the claimed invention;
FIG. 2 is a claimed cross-sectional view successively illustrating a process of manufacturing the circuit element package of FIG. 1 according to an exemplary embodiment which falls within the scope of the claimed invention;
FIG. 3A is a non-claimed cross-sectional view illustrating an interval between a first shielding layer and a BGA of a semiconductor chip in the case of shielding the semiconductor chip only, according to an exemplary embodiment;
FIGS. 3B and 3C are a non-claimed perspective view and a cross-sectional view illustrating a circuit element package using epoxy resin to achieve firm coupling between a semiconductor chip and a printed circuit board, according to an exemplary embodiment;
FIG. 4A is a non-claimed schematic block diagram illustrating a material supply device for forming a shielding layer and an insulating layer of a circuit element package, according to an exemplary embodiment;
FIG. 4B is a non-claimed plan view illustrating a path through which a nozzle moves to form a first shielding layer, according to an exemplary embodiment;
FIG. 5 is a non-claimed view illustrating a discharge port through which a material for forming a first shielding layer is discharged through the nozzle illustrated in FIG. 4B;
FIG. 6 is a non-claimed view illustrating a process of forming a first shielding layer by twice moving a nozzle along a path to highly form the first shielding layer, according to an exemplary embodiment;
FIG. 7 is a non-claimed view illustrating a discharge port formed on a nozzle in upward and downward directions, according to an exemplary embodiment;
FIG. 8 is a non-claimed view illustrating a lower end portion of a nozzle that is bent substantially in a horizontal direction, according to an exemplary embodiment;
FIG. 9 is a non-claimed view illustrating a state in which a second shielding layer is formed through a nozzle, according to an exemplary embodiment;
FIG. 10 is a non-claimed view illustrating a process of forming an insulating layer in a jetting method, according to an exemplary embodiment;
FIG. 11 is a non-claimed cross-sectional view illustrating a circuit element package according to another exemplary embodiment;
FIG. 12 is a non-claimed cross-sectional view successively illustrating a process of manufacturing the circuit element package of FIG. 11, according to another exemplary embodiment;
FIG. 13 is a non-claimed cross-sectional view illustrating a circuit element package according to still another exemplary embodiment;
FIG. 14 is a non-claimed cross-sectional view illustrating a circuit element package according to still another exemplary embodiment;
FIG. 15 is a non-claimed cross-sectional view illustrating a circuit element package according to still another exemplary embodiment;
FIG. 16 is a non-claimed cross-sectional view illustrating a circuit element package according to still another exemplary embodiment;
FIG. 17 is a non-claimed cross-sectional view illustrating a circuit element package according to still another exemplary embodiment;

FIGS. 18A and 18B are non-claimed plan views illustrating a second shielding layer according to exemplary embodiments;

FIG. 19 is a non-claimed view successively illustrating a process of manufacturing a circuit element package according to still another exemplary embodiment;

FIG. 20 is a non-claimed cross-sectional view illustrating a circuit element package according to still another exemplary embodiment;

FIGS. 21A and 21B are non-claimed perspective views illustrating an upper portion and a lower portion of an insulating mold illustrated in FIG. 20;

FIG. 22 is a non-claimed cross-sectional view illustrating a circuit element package according to still another exemplary embodiment;

FIG. 23 is a non-claimed cross-sectional view illustrating a circuit element package according to still another exemplary embodiment;

FIG. 24 is a non-claimed perspective view illustrating an insulating mold illustrated in FIG. 23;

FIG. 25 is a non-claimed cross-sectional view illustrating a circuit element package according to still another exemplary embodiment;

FIG. 26 is a non-claimed cross-sectional view illustrating a circuit element package according to still another exemplary embodiment;

FIG. 27 is a non-claimed view illustrating a process of manufacturing the circuit element package illustrated in FIG. 26, according to still another exemplary embodiment;

FIG. 28 is an enlarged non-claimed view illustrating portion "A" in FIG. 27;

FIG. 29 is a non-claimed view illustrating a process of manufacturing a circuit element package according to still another exemplary embodiment; and

FIG. 30 is a non-claimed view illustrating a process of manufacturing a circuit element package according to still another exemplary embodiment.

**Mode of the Invention**

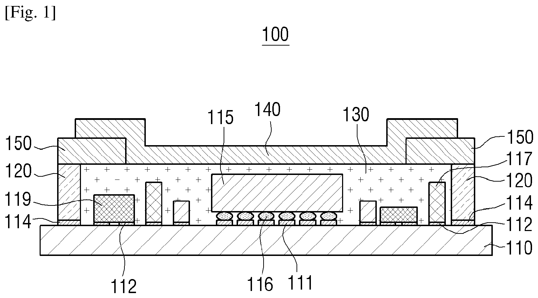

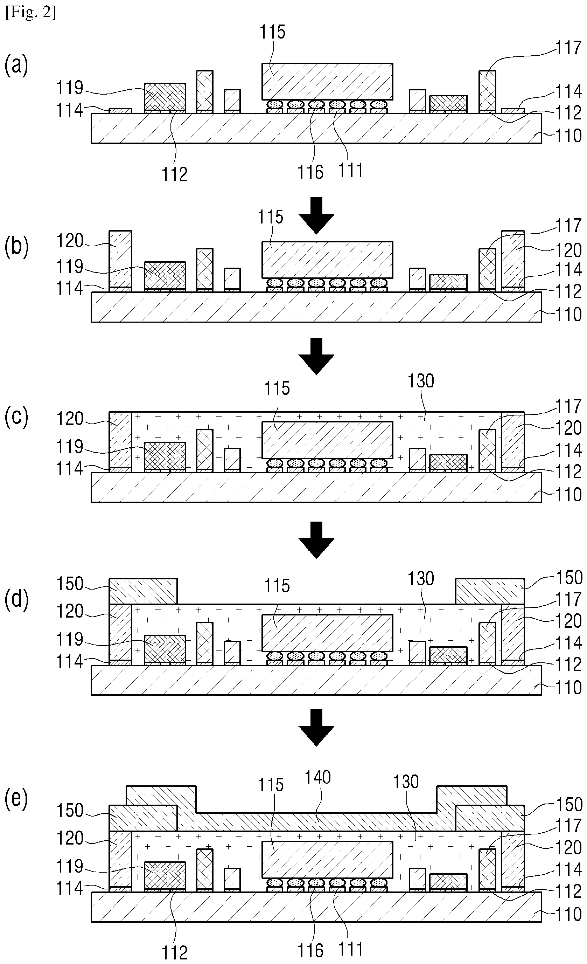

The presently claimed invention is depicted and described with reference to Figs. 1 and 2 while the remaining figures present other embodiments which do not fall within the scope of the claimed invention.

Exemplary embodiments are described in greater detail below with reference to the accompanying drawings.

In the following description, like drawing reference numerals are used for like elements, even in different drawings. The matters defined in the description, such as detailed construction and elements, are provided to assist in a comprehensive understanding of the exemplary embodiments. Also, well-known functions or constructions may not be described in detail because they would obscure the description with unnecessary detail.

It will be understood that the terms "comprises" and/or "comprising" used herein specify the presence of stated features or components, but do not preclude the presence or addition of one or more other features or components. In addition, the terms such as "unit," "-er (-or)," and "module" described in the specification refer to an element for performing at least one function or operation, and may be implemented in hardware, software, or the combination of hardware and software. Further, in exemplary embodiments, a structure of a circuit element package that shields a semiconductor chip and passive elements together is exemplarily described and falls within the scope of the claimed invention.

A structure that shields only the semiconductor chip falls within the scope of the claimed invention and a structure that shields only passive elements may also be described, yet this structure does not fall within the scope of the claimed invention.

Further, a circuit element package according to exemplary embodiments may be applied to a smart phone, a display device, and a wearable device.

FIG. 1 is a claimed cross-sectional view illustrating a circuit element package 100 according to an exemplary embodiment.

Referring to FIG. 1, the circuit element package 100 includes a printed circuit board 110, a semiconductor chip 115 mounted on the printed circuit board 110, and passive elements 117 and 119. On an upper surface of the printed circuit board 110, a first connection pad 111 and a second connection pad 112 are patterned to electrically connect the semiconductor chip 115 and the passive elements 117 and 119 to the printed circuit board 110. A plurality of first and second connection pads 111 and 112 are provided. The first and second connection pads 111 and 112 may be formed for grounding or signal transfer of the semiconductor chip 115 and the passive elements 117 and 119.

A ground pad 114 is patterned on an upper surface of the printed circuit board 110. The ground pad 114 may be formed for grounding or signal transfer of the semiconductor chip 115 and the passive elements 117 and 119. The ground pad 114 is grounded to a first shielding layer 120.

The semiconductor chip 115 includes a plurality of connection terminals 116 that are electrically connected to the first connection pads 111 of the printed circuit board 110. The plurality of connection terminals 116 may be formed, for example, in a BGA (Ball Grid Array) method to be solder balls, and may be referred to as a BGA 116.

The passive elements 117 and 119 (e.g., resistors, capacitors, and inductors) may include at least one connection terminal that is electrically connected to the second connection pad 112 of the printed circuit board 110. The height of the passive elements 117 and 119 that are mounted on the printed circuit board 110 may be lower or higher than the height of the semiconductor chip 115, and the semiconductor chip 115 and the passive elements 117 and 119 are covered by the insulating layer 130 to be isolated from the first shielding layer 120.

The circuit element package 100 includes the first shielding layer 120, an insulating layer 130, a second shielding layer 140, and an edge bridge 150 on the printed circuit board 110.

The first and second shielding layers 120 and 140 and the edge bridge 150 are be formed of a material having electromagnetic shielding characteristics that prevents electromagnetic interference (EMI). Accordingly, the first and second shielding layers 120 and 140 and the edge bridge 150 shield electromagnetic waves generated from the semiconductor chip 115 and the passive elements 117 and 119, and thus prevents in advance the EMI that may be given to other electronic components mounted on an electronic device that includes the circuit element package 100. Accordingly, obstacles, such as electromagnetic noise and malfunction, is intercepted in the electronic device that includes the circuit element package 100, and thus reliability of the product is be prevented from deteriorating. As described above, the first and second shielding layers 120 and 140 can prevent the electromagnetic waves that are unavoidably generated during an operation process of the circuit element package 100 from exerting an influence on an outside.

The first shielding layer 120 forms a side surface of the shielding layer, and the second shielding layer 140 forms an upper surface of the shielding layer. The first and second shielding layers 120 and 140 cover the insulating layer 130.

The first shielding layer 120 is connected to the ground pad 114, and may be in a closed loop shape to surround the semiconductor chip 115 and the passive elements 117 and 119. For example, the first shielding layer 120 may be in a rectangular shape, but is not limited thereto.

The insulating layer 130 is formed inside the first and second shielding layers 120 and 140, and covers the semiconductor chip 115 and the passive elements 117 and 119. The insulating layer 130 isolates the semiconductor chip 115 and the passive elements 117 and 119 from the first and second shielding layers 120 and 140.

The insulating layer 130 is made of a material having fluidity so that it is injected into a region that is partitioned by the first shielding layer 120 in a dam shape and comes in close contact with the outsides of the semiconductor chip 115 and the passive elements 117 and 119. Further, the insulating layer 130 may isolate the connection pad 112 (one among the connection pads 111 and 112) that is arranged in the outermost portion from the ground pad 114.

The insulating layer that is injected into a partition region of the first shielding layer 120 is cured in a predetermined shape through a curing process, such as ambient curing, thermal curing, or UV curing.

The insulating layer 130 may be formed using a thixotropic material or a hot melt material. The first shielding layer 120, the second shielding layer 140, and the edge bridge 150 may also be formed using the thixotropic material or hot melt material.

The thixotropic material may include at least one among synthetic fine silica, bentonite, fine particle surface processing calcium carbonate, hydrogenated castor oil, metal soap, aluminum stearate, polyamide wax, polyethylene oxide, and linseed polymerized oil. For example, metal soap may include aluminum stearate.

A hot melt material may include at least one among polyurethane, polyurea, polyvinyl chloride, polystyrene, ABS (Acrylonitrile Butadiene Styrene), polyamide, acryl, and PBTP (Polybutylene Terephthalate).

The thixotropic material or the hot melt material may be cured through UV curing or thermal curing. The thixotropic material or the hot melt material having fluidity can be easily injected through a dispenser, and then can be cured through UV curing or thermal curing to seek process convenience. The thixotropic material may be polymer including metal filler.

Further, the insulating layer 130, the first and second shielding layers 120 and 140, and the edge bridge 150 according to an exemplary embodiment may be formed through 3D printing. Accordingly, costs for expensive equipment and manufacturing time can be saved.

The second shielding layer 140 may be formed by spreading the material that is discharged from the dispenser so that the material covers the upper surface of the insulating layer 130 and the upper surface of the edge bridge 150. The second shielding layer 140 may also be made of the same material as the material of the first shielding layer 120, and the viscosity of the second shielding layer 140 may also be set to be the same as the viscosity of the first shielding layer 120.

The edge bridge 150 is formed to cover the boundary between the first shielding layer 120 and the insulating layer 130 and the periphery thereof. For example, the edge bridge 150 may be formed to be bent at about 90° so that the edge bridge 150 is laminated on the upper surface of the first shielding layer 120 and covers the peripheral portion of the insulating layer 130. As described above, because the edge bridge 150 connects the first and second shielding layers 120 and 140 to each other, the ground region can be extended from the first shielding layer 120 to the second shielding layer 140.

The edge bridge 150 may be made of the same material as the first and second shielding layers 120 and 140, i.e., a material having the electromagnetic shielding characteristics. As described above, the edge bridge 150 that is provided in the circuit element package 110 according to an exemplary embodiment can shield the electromagnetic waves that are generated from the semiconductor chip 115 and the passive elements 117 and 119 more effectively together with the first and second shielding layers 120 and 140.

FIG. 2 is a claimed cross-sectional view successively illustrating a process of manufacturing the circuit element package 100 of FIG. 1 according to an exemplary embodiment.

Referring to portion (a) of FIG. 2, the connection pads 111 and 112 and the ground pad 114 are patterned on the upper surface of the printed circuit board 110, and then the semiconductor chip 115 and the passive elements 117 and 119 are bonded to the connection pads 111 and 112 so that the semiconductor chip 115 and the passive elements 117 and 119 are electrically connected to the connection pads 111 and 112.

Referring to portion (b) of FIG. 2, the first shielding layer 120 is formed on the upper surface of the printed circuit board 110 to be connected to the ground pad 114. The first shielding layer 120 may be substantially in a closed loop shape to surround the semiconductor chip 115 and the passive elements 117 and 119. In this case, the first shielding layer 120 is made of a fluid material having high viscosity so that the first shielding layer 120 is formed to be higher than the semiconductor chip 115 and the passive elements 117 and 119.

Referring to portion (c) of FIG. 2, the insulating layer 130 is formed on the inside of the first shielding layer 120 that is formed substantially in a dam shape. The material that forms the insulating layer 130 may have lower viscosity than the viscosity of the material of the first shielding layer 120 so that the material of the insulating layer 130 has higher fluidity than the fluidity of the material that forms the first shielding layer 120. The material that forms the insulating layer 130 (any one among a thixotropic material, a hot melt material, and a polymer including a metal filler) secures high fluidity, and fills between the semiconductor chip 115 and the passive elements 117 and 119 and the upper surface of the printed circuit board 110 when the material of the insulating layer 130 is injected into the shielding region that is partitioned by the first shielding layer 120. The fluid material that is injected with a predetermined height is cured through the ambient curing, UV curing, or thermal curing process.

Referring to portion (d) of FIG. 2, the edge bridge 150 is formed to simultaneously overlap the upper surface of the first shielding layer 120 and the upper surface of the insulating layer 130. In this case, because the edge bridge 150 is limitedly spread on the peripheral portion of the upper surface of the insulating layer 130, a space (roughly in a groove shape), into which the second shielding layer 140 to be formed in the next process is to be injected, may be provided in the center portion of the upper surface of the insulating layer 130 due to a step height that is caused by the thickness of the edge bridge 150.

Referring to portion (e) of FIG. 2, the second shielding layer 140 is formed on the upper surface of the cured insulating layer 130 and the upper surface of the edge bridge 150. In this case, because the first shielding layer 120 that is connected to the ground pad 114 is electrically connected to the second shielding layer 140 through the edge bridge 150, the ground region can be extended up to the upper surface of the second shielding layer 140, and thus a stable ground path can be provided.

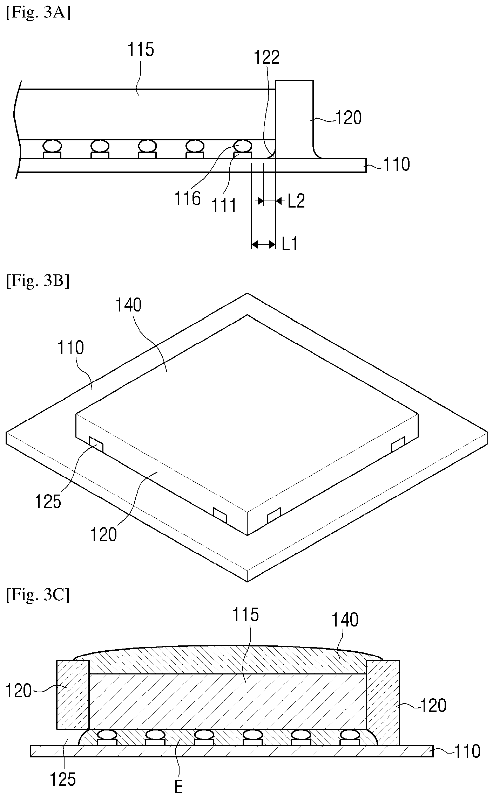

In an exemplary embodiment, the circuit element package is configured to shield the semiconductor chip 115 only, as shown in FIGS. 3A to 3C, without shielding both the semiconductor chip 115 and the passive elements 117 and 119.

FIG. 3A is a non-claimed cross-sectional view illustrating an interval between the first shielding layer 120 and the BGA 116 of the semiconductor chip 115 in the case of shielding the semiconductor chip 115 only, according to an exemplary embodiment.

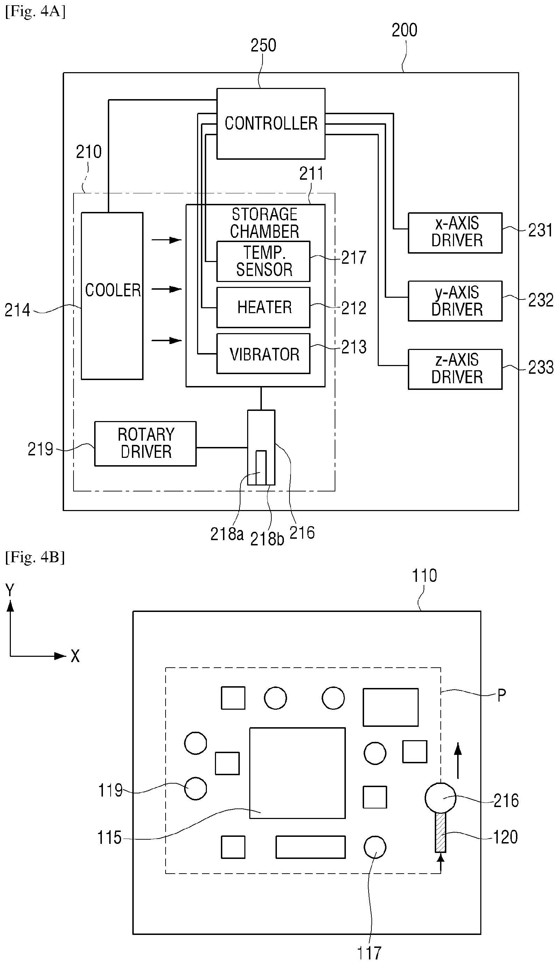

Referring to FIG. 3A, in the case of shielding only the semiconductor chip 115, the outermost terminal of the BGA (Ball Grid Array) 116 that includes electrodes formed on the bottom surface of the semiconductor chip 115 is electrically insulated from the first shielding layer 120. For this, the material supplied through a nozzle 216 (of FIG. 4A) does not come in contact with the BGA 116 by controlling a distance in which the material is injected onto the bottom surface of the semiconductor chip 115 through adjustment of the physical properties (surface tension, viscosity, density, and thixotropy) of the material that forms the first shielding layer 120 and material supply variables (supply pressure, transport speed, material supply amount, gap of a semiconductor chip supply device, and gap of a printed circuit board supply device). That is, if it is assumed that the distance between the outer surface of the semiconductor chip 115 and the outermost BGA 116 is L1 and a length of an underfill 122 of the material that forms the first shielding layer 120, which is directed from the outer surface of the semiconductor chip 115 to the outermost BGA 116 is L2, the condition of L1>L2 is satisfied.

FIGS. 3B and 3C are a non-claimed perspective view and a cross-sectional view illustrating a circuit element package using epoxy resin to achieve firm coupling between the semiconductor chip 115 and the printed circuit board 110, according to an exemplary embodiment.

Referring to FIGS. 3B and 3C, in the case in which an epoxy underfill E is used as one among methods for mounting a semiconductor chip 115 to improve reliability of the products through an increase of an attachment force between the semiconductor chip 115 and the printed circuit board 110, the shielding structure according to an exemplary non-claimed embodiment may be modified to be applied.

That is, the material that forms the shielding layer is a polymer-based material that is similar to the material of the underfill, and thus can be cured through ambient curing or thermal curing simultaneously with the underfill. However, if the outline of the underfill material is completely surrounded by the material that forms the shielding layer, gas that is included in the epoxy underfill E is confined in the shielding structure during curing of the epoxy underfill E. Accordingly, the circuit element package may cause a reliability problem when the temperature is increased. To prevent this, gas discharge holes 125 are formed at predetermined intervals in partial positions or portions of the first shielding layer 120, and correspond to a gap portion between the semiconductor chip 115 and the printed circuit board 110 to discharge the generated gas.

FIG. 4A is a non-claimed schematic block diagram illustrating a material supply device 200 for forming a shielding layer and an insulating layer of a circuit element package, according to an exemplary embodiment. The material supply device 200 may be a 3D printer.

The material supply device 200 to be described hereinafter includes one dispenser 210 and one nozzle 216 provided on the dispenser 210, but is not limited thereto. A plurality of dispensers may be provided in the material supply device 200. Dispensers for forming the shielding layer and the insulating layer may be provided, dispensers for forming the side surface and the upper surface of the shielding layer may be provided, and dispensers for forming the side surface and the upper surface of the insulating layer may be provided, respectively.

Referring to FIG. 4A, the material supply device 200 includes the dispenser 210 configured to store and discharge the material, and an X-axis driver 231, a Y-axis driver 232, and a Z-axis driver 233 configured to move the dispenser 210 in the directions of X, Y, and Z-axes. Further, the material supply device 200 includes a controller 250 configured to control the dispenser 210, the X-axis driver 231, the Y-axis driver 232, and the Z-axis driver 233.

The dispenser 210 includes a storage chamber 211 in which the material is stored, a heater 212 configured to control the viscosity of the material, a vibrator 213, a cooler 214, and a temperature sensor 217. The heater 212, the vibrator 213, and the temperature sensor 217 may be arranged in predetermined positions inside the storage chamber 211. The cooler 214 may be arranged in a position that is adjacent to the storage chamber 211 outside the storage chamber 211. The cooler 214 may be a cooling fan that blows a cooled air toward the storage chamber 211, or a cooling pipe in which cooling water flows. Further, the dispenser 210 includes nozzle 216 configured to discharge the material that is supplied from the storage chamber 211 to the outside.

In an exemplary non-claimed embodiment, to form the first and second shielding layers 120 and 140 and the insulating layer 130 with a predetermined thickness or a uniform thickness, the amount of the material that is supplied from the storage chamber 211 to the nozzle 216 may be kept constant. In this case, because the supply amount of the material is affected by the density, viscosity, and surface tension of the material, such physical property values are controlled. In an exemplary non-claimed embodiment, to control the physical property values of the material, the controller 250 may change the temperature of the material through driving of the heater 212 and the cooler 214, and may vary or maintain a desired viscosity of the material through determination of the temperature value of the material that is detected by the temperature sensor 217.

Further, the viscosity of the material may be artificially controlled through application of a shear stress to the material using the thixotropy of the material. To control the shear stress of the material in real time, a desired viscosity can be maintained through adjustment of the frequency and the amplitude of the vibrator 213 arranged in the storage chamber 211. As described above, in the case of using the same material, the formation efficiency can be heightened by differently controlling the viscosity of the material. For example, to improve the formation speed in the case in which the first shielding layer 120 is formed in a high aspect ratio r, the material has high viscosity (about 200,000 cP). Unlike this, in the case of forming the second shielding layer 140 that has a larger area than the area of the first shielding layer 120, the material is injected by moving the dispenser 210 at high speed. In this case, the material that fills between the first shielding layer 120 that is pre-provided to form the side surface of the shielding layer, the semiconductor chip 115, and the passive elements 117 and 119 has low viscosity (about 4,000 cP) and thus has high fluidity.

Accordingly, in an exemplary non-claimed embodiment, in the case of forming the second shielding layer 140 that forms the upper surface of the shielding layer, the viscosity may be lowered through application of the shear stress to the material through the vibrator 214. On the other hand, in the case of mixing a large amount of solvent to obtain a low-viscosity material during forming of the second shielding layer, the dispersion stability of the metal filler deteriorates, and it is difficult to obtain uniform shielding performance during curing. Accordingly, the same material viscosity control using the thixotropy of the material is a technology that is used for high-speed formation.

As described above, in an exemplary non-claimed embodiment, the viscosity of the same material stored in the storage chamber 211 can be varied through control of the temperature and thixotropy of the material without replacing and filling different materials by viscosities in the storage chamber 211, and thus the supply amount and the viscosity of the material can be precisely controlled.

Further, the dispenser 210 is connected to a rotary driver 219 that can rotate the nozzle 216 in forward and reverse directions around a center shaft of the nozzle 216. The rotary driver 219 can transfer a rotating force to the nozzle 216 through a power transfer method. The controller 250 may move the nozzle 216 in a linear direction along a formation path P (of FIG. 4B) of the first shielding layer 120, and then may rotate the nozzle 216 at about 90° through the rotary driver 219 at a corner portion of the formation path P of the first shielding layer 120. Accordingly, the material can be continuously discharged from the dispenser 210.

Further, the rotary driver 210 may rotate the storage chamber 211 through the power transfer method, and in this case, the nozzle 216 may be fixedly installed at a lower end of the storage chamber 211.

FIG. 4B is a non-claimed plan view illustrating a path through which the nozzle 216 moves to form the first shielding layer 120, according to an exemplary embodiment.

Referring to FIG. 4B, the formation path P of the first shielding layer 120 forms a closed loop to surround the semiconductor chip 115 and the passive elements 117 and 119 to be shielded. In this case, the formation path P of the first shielding layer 120 is in a rectangular shape.

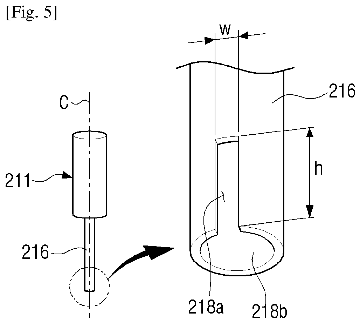

FIG. 5 is a non-claimed view illustrating a discharge port through which a material for forming a first shielding layer is discharged through the nozzle 216 illustrated in FIG. 4B.

Referring to FIGS. 4A and 5, the nozzle 216 includes a first discharge port 218a formed on a side surface of a lower portion of the nozzle 216 to discharge the material, and a second discharge port 218b formed on a bottom surface thereof to discharge the material. The first and second discharge ports 218a and 218b communicate with each other.

As described above, the first discharge port 218a is asymmetrically formed about the center shaft C of the nozzle 216. Further, the first discharge port 218a may be in a rectangular shape that is similar to the final cross section of the first shielding layer 120 to form the first shielding layer 120 having a high aspect ratio.

In an exemplary non-claimed embodiment, the first discharge port 218a may be used at a numerical value that indicates a value that is obtained by dividing the height h of the first discharge port 218a by the width w of the first discharge port 218a. That is, in an exemplary non-claimed embodiment, the aspect ratio r of the first discharge port 218a may be represented by the following equation 1.

$$[\text{Equation 1}]$$
$$\text{Aspect ratio } r = h/w$$

Through such a shape of the first discharge port 218a, the first shielding layer 120 has a high aspect ratio structure in which the thickness thereof is thin and the height thereof is high.

On the other hand, as moving along the predetermined path P (of FIG. 4B), the nozzle 216 may discharge the material simultaneously to a point that is adjacent to the semiconductor chip 115 and/or the passive elements 117 and 119 (in the case of shielding the semiconductor chip 115 only, the side wall of the semiconductor chip 115) and the upper surface of the printed circuit board 110 through the first and second discharge ports 218a and 218b to form the first shielding layer 120.

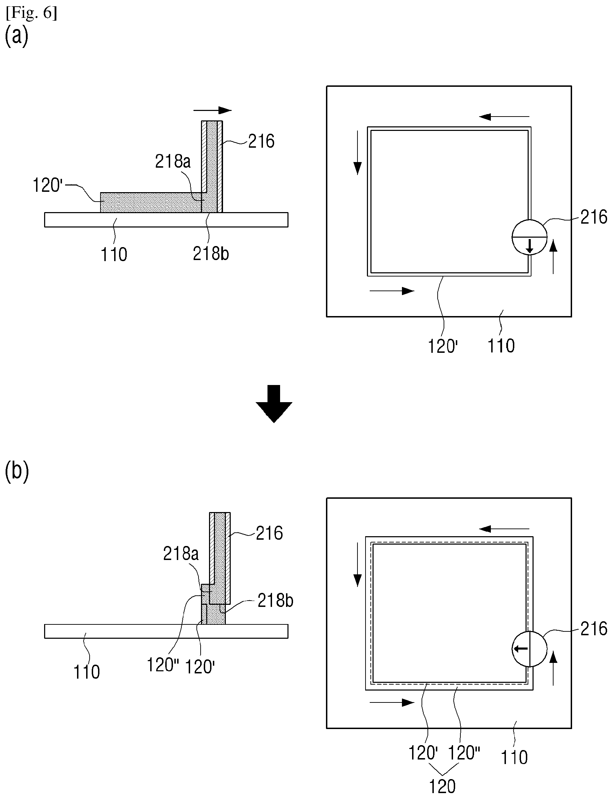

FIG. 6 is a non-claimed view illustrating a process of forming the first shielding layer 120 by twice moving the nozzle 216 along a path to highly form the first shielding layer 120, according to an exemplary embodiment.

Referring to portion (a) of FIG. 6, as moving along the first shielding layer forming path P (of FIG. 4B), the nozzle 216 discharges the material through the first and second discharge ports 218a and 218b. Accordingly, a lower portion 120' of the first shielding layer 120 may be formed. In this case, the first discharge port 218a is arranged toward an opposite direction to the moving direction of the nozzle 216. Referring to portion (b) of FIG. 6, after the height of the nozzle 216 is upwardly adjusted, the nozzle 216 discharges the material through the first and second discharge ports 218a and 218b as moving along the upper portion of the first shielding layer 120 so that an upper portion 120" of the first shielding layer is formed on the basis of the lower portion 120' of the first shielding layer 120.

In this case, the first discharge port 218a is arranged in a direction that is perpendicular to the moving direction of the nozzle 216 so that the first discharge port 218a is directed toward the lower portion 210' of the first shielding layer 120. Accordingly, the material that is discharged to the first discharge port 218a is formed on an upper surface of the lower portion 120' of the first shielding layer 120, and the material that is discharged to the second discharge port 218b is formed to cover an outer surface of the lower portion 120' of the first shielding layer 120. The discharge amount of the material for forming the upper portion 120" of the first shielding layer 120 is larger than the discharge amount of the material for forming the lower portion 120' of the first shielding layer 120.

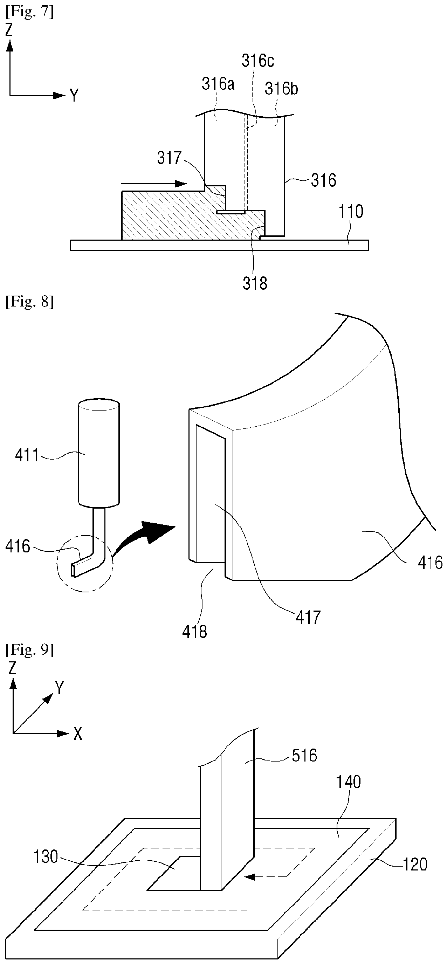

FIG. 7 is a non-claimed view illustrating a discharge port formed on a nozzle 316 in upward and downward directions, according to an exemplary embodiment. Referring to FIG. 7, the nozzle 316 may be formed to include two discharge ports 317 and 318 on upper and lower portions of the discharge port. The upper discharge port 317 and the lower discharge port 318 respectively communicate with first and second material supply paths 316a and 316b that are separated from each other by a partition 316c. The upper discharge port 317 and the lower discharge port 318 may be formed to have the same width, or the width of the lower discharge port 318 is larger than the width of the upper discharge port 317. Further, the upper discharge port 317 and the lower discharge port 318 may be formed to have the same height, or the upper discharge port 317 and the lower discharge port 318 are formed to have different heights.

As described above, in the case in which the nozzle 316 includes the upper and lower discharge ports 317 and 318, the material may be discharged from the upper and lower discharge ports 317 and 318 simultaneously or with a time difference between them. For example, the lower discharge port 318 is arranged more forward than the upper discharge port 317 in the moving direction of the nozzle, and in this case, the material that is discharged from the upper discharge port 317 is formed on an upper side of the material that is earlier discharged from the lower discharge port 318. For this, at a start time to form the first shielding layer 120, the nozzle 316 discharges the material through the lower discharge port 318 simultaneously with moving along the formation path of the first shielding layer 120, and with a time difference from the time to discharge the material through the lower discharge port 318, the nozzle 316 discharges the material through the upper discharge port 317.

As described above, in an exemplary non-claimed embodiment, the nozzle 316 discharges the material simultaneously through the upper and lower discharge ports 317 and 318 as once moving along the predetermined formation path P (of FIG. 4B) of the first shielding layer 120, thereby forming the first shielding layer 120 having the high aspect ratio r.

In an exemplary non-claimed embodiment, two upper and lower discharge ports 317 and 318 are provided on the upper and lower portions of the nozzle 316, but are not limited thereto. Three or more discharge ports are provided in upward and downward directions. In this case, the number of divided discharge ports may be set in consideration of both the discharge flow rate and the viscosity of the material so that the formed first shielding layer 120 can maintain its height.

FIG. 8 is a non-claimed view illustrating a lower end portion of a nozzle 416 that is bent substantially in a horizontal direction, according to an exemplary embodiment.

Referring to FIG. 8, a lower end portion of the nozzle 416 that is formed at a lower end of a storage chamber 411 is bent substantially in a horizontal direction. In this case, a first discharge port 417 is formed at the bent end portion of the nozzle 416, and a second discharge port 418 that communicates with the first discharge port 417 is formed on the lower side of the first discharge port 417. In the same manner as the first discharge port 218a of the nozzle 216 as described above, the first discharge port 417 is formed with the high aspect ratio r of the width w and the height h.

FIG. 9 is a non-claimed view illustrating a state in which the second shielding layer 140 is formed through a nozzle 516, according to an exemplary embodiment.

Referring to FIG. 9, a low-viscosity material may be used to form a film with a predetermined thickness as increasing the supply amount of the material when the second shielding layer 140 is formed on the upper surface of the insulating layer 130. The nozzle 516 has a flat lower end. Further, the nozzle 516 may move from the outline of the upper surface of the insulating layer 130 toward the center thereof substantially in a spiral direction, and thus the second shielding layer 140 can be formed at high speed.

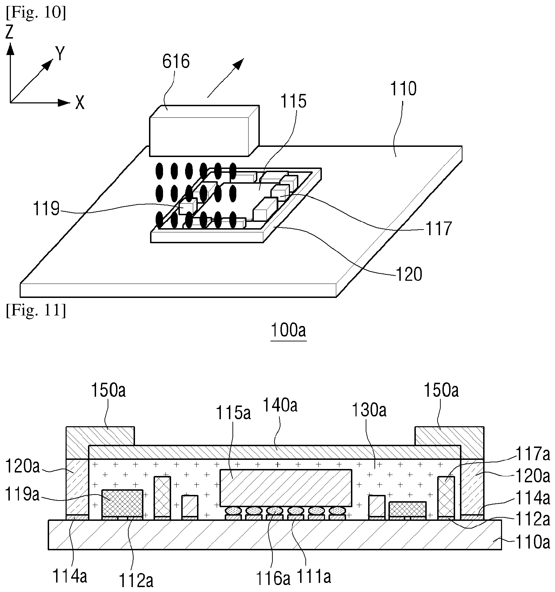

FIG. 10 is a non-claimed view illustrating a process of forming the insulating layer 130 a jetting method, according to an exemplary embodiment.

Referring to FIG. 10, to conformally coat the surfaces of passive elements 117 and 119 having various heights, a material that is composed of low-viscosity insulating ink may be used. In this case, a nozzle 616 has a structure that selects a region (e.g., shielding region partitioned by the first shielding layer 120 that is in a dam shape) and discharges the insulating ink in the jetting method.

The insulating ink may be properly limited in ink viscosity, surface tension, and wetting degree to conformally form the surface of the insulating layer 130. Further, solventless type insulating ink may be used to prevent the surfaces (upper end surfaces) of the passive elements 117 and 119 from being exposed due to the thickness reduction caused by the curing and to prevent cracks from occurring due to the trapped solvent. In addition, a UV curing process or a curing process in which UV and heat are simultaneously applied may be performed to make it possible to rapidly cure the insulating layer 130 that is injected by the jetting.

FIG. 11 is a non-claimed cross-sectional view illustrating a circuit element package 100a according to another exemplary embodiment.

Referring to FIG. 11, the circuit element package 100a includes a printed circuit board 110a, a semiconductor chip 115a mounted on the printed circuit board 110a, and passive elements 117a and 119a. On an upper surface of the printed circuit board 110a, a first connection pad 111a and a second connection pad 112a are patterned to electrically connect the semiconductor chip 115a and the passive elements 117a and 119a to the printed circuit board 110a. A plurality of first and second connection pads 111a and 112a are provided. The first and second connection pads 111a and 112a may be formed for grounding or signal transfer of the semiconductor chip 115a and the passive elements 117a and 119a.

A ground pad 114a is patterned on an upper surface of the printed circuit board 110a. The ground pad 114a may be formed for grounding or signal transfer of the semiconductor chip 115a and the passive elements 117a and 119a. The ground pad 114a is grounded to a first shielding layer 120a.

The semiconductor chip 115a includes a plurality of connection terminals 116a that are electrically connected to the first connection pads 111a of the printed circuit board 110a. The plurality of connection terminals 116a may be formed, for example, in a BGA method to be solder balls, and may be referred to as a BGA 116a.

The passive elements 117a and 119a (e.g., resistors, capacitors, and inductors) may include at least one connection terminal that is electrically connected to the second connection pad 112a of the printed circuit board 110a. The height of the passive elements 117a and 119a that are mounted on the printed circuit board 110a may be lower or higher than the height of the semiconductor chip 115a, and the semiconductor chip 115a and the passive elements 117a and 119a are covered by an insulating layer 130a to be isolated from the first shielding layer 120a.

The circuit element package 100a includes the first shielding layer 120a, the insulating layer 130a, a second shielding layer 140a, and an edge bridge 150a on the printed circuit board 110a.

The first and second shielding layers 120a and 140a may be formed of a material having electromagnetic shielding characteristics, and the first and second shielding layers 120a and 140a can prevent the electromagnetic waves that are unavoidably generated during an operation process of the circuit element package 100 from exerting an influence on an outside.

The first and second shielding layers 120a and 140a cover the insulating layer 130a. The first shielding layer 120a is connected to the ground pad 114a, and may be in a closed loop shape to surround the semiconductor chip 115a and the passive elements 117a and 119a.

The insulating layer 130a is formed inside the first and second shielding layers 120a and 140a, and covers the semiconductor chip 115a and the passive elements 117a and 119a. The insulating layer 130a may isolate the semiconductor chip 115a and the passive elements 117a and 119a from the first and second shielding layers 120a and 140a.

The insulating layer 130a may be made of a material having fluidity so that it is injected into a region that is partitioned by the first shielding layer 120a in a dam shape and comes in close contact with the outsides of the semiconductor chip 115a and the passive elements 117a and 119a. Further, the insulating layer 130a may isolate the connection pad 112a (one among the connection pads 111a and 112a) that is arranged in the outermost portion and the ground pad 114a from each other. The insulating layer 130a that is injected into a partition region of the first shielding layer 120a may be cured in a predetermined shape through a curing process, such as ambient curing, thermal curing, or UV curing. The insulating layer 130a may be formed using a thixotropic material or a hot melt material. Further, the first shielding layer 120a and the edge bridge 150a may also be formed using the thixotropic material or hot melt material.

The second shielding layer 140a may be laminated and formed on the upper surface of the cured insulating layer 130a. The second shielding layer 140a may be a shielding film having electromagnetic shielding characteristics. The shielding film has a predetermined thickness and may be attached to the upper surface of the insulating layer 130a.

The edge bridge 150a is formed to cover the boundary between the first shielding layer 120a and the second shielding layer 140a and the periphery thereof. For example, the edge bridge 150a may be formed to be bent at about 90° so that the edge bridge 150a is laminated on the upper surface of the first shielding layer 120a and covers the peripheral portion of the second shielding layer 140a. As described above, because the edge bridge 150a connects the first and second shielding layers 120a and 140a to each other, the ground region can be extended from the first shielding layer 120a to the second shielding layer 140a.

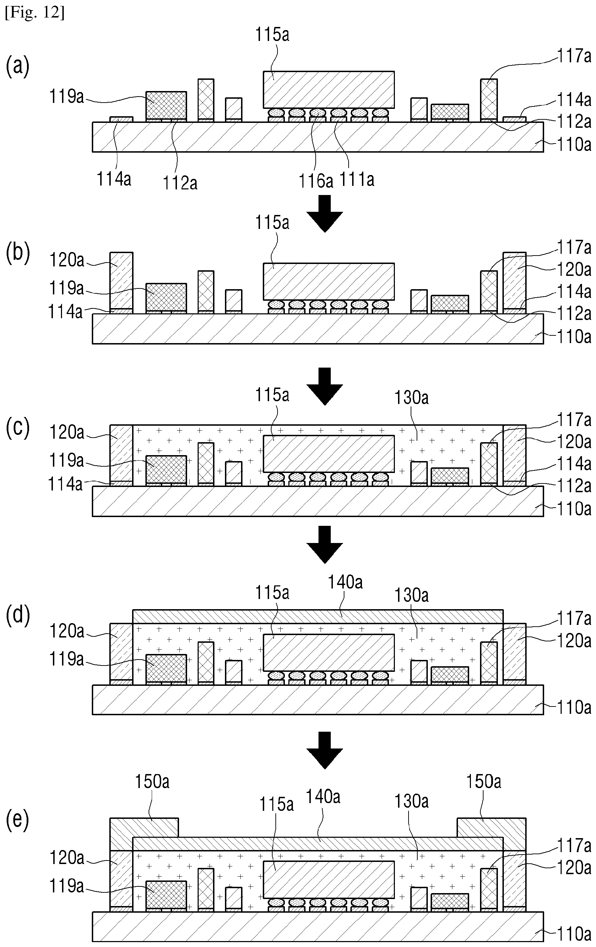

FIG. 12 is a non-claimed cross-sectional view successively illustrating a process of manufacturing the circuit element package 100a of FIG. 11, according to another exemplary embodiment.

Referring to portion (a) of FIG. 12, the connection pads 111a and 112a and the ground pad 114a are patterned on the upper surface of the printed circuit board 110a, and then the semiconductor chip 115a and the passive elements 117a and 119a are bonded to the connection pads 111a and 112a so that the semiconductor chip 115a and the passive elements 117a and 119a are electrically connected to the connection pads 111a and 112a.

Referring to portion (b) of FIG. 12, the first shielding layer 120a is formed on the upper surface of the printed circuit board 110a to be connected to the ground pad 114a. The first shielding layer 120a may be substantially in a closed loop shape to surround the semiconductor chip 115a and the passive elements 117a and 119a. Referring to portion (c) of FIG. 12, the insulating layer 130a is formed on the inside of the first shielding layer 120a that is formed substantially in a dam shape. The material that forms the insulating layer 130a may have lower viscosity than the viscosity of the material of the first shielding layer 120a so that the material of the insulating layer 130a has higher fluidity than the fluidity of the material that forms the first shielding layer 120a. The material that forms the insulating layer 130a secures high fluidity, and may fill between the semiconductor chip 115a and the passive elements 117a and 119a and the upper surface of the printed circuit board 110a when the material of the insulating layer 130a is injected into the shielding region that is partitioned by the first shielding layer 120a. The fluid material that is injected with a predetermined height is cured through the ambient curing, UV curing, or thermal curing process.

Referring to portion (d) of FIG. 12, the second shielding layer 140a is formed on the upper surface of the cured insulating layer 130a. The second shielding layer 140a may be a shielding film having a predetermined thickness, and may have an area that is substantially equal to or somewhat larger than the upper surface of the insulating layer 130a. In this case, because adhesives are spread on the bottom surface of the second shielding layer 140a, the second shielding layer 140a may be attached to the upper surface of the insulating layer 130a.

Referring to portion (e) of FIG. 12, the edge bridge 150a is formed to simultaneously overlap the upper surfaces of the first shielding layer 120a and the second shielding layer 140a. The edge bridge 150a may fill a gap between the first and second shielding layers 120a and 140a, and may electrically connect the upper surface of the first shielding layer 120a and the peripheral portion of the second shielding layer 140a to each other. In this case, because the first shielding layer 120a that is connected to the ground pad 114a is electrically connected to the second shielding layer 140a through the edge bridge 150a, the ground region can be extended up to the upper surface of the second shielding layer 140a, and thus a stable ground path can be provided.

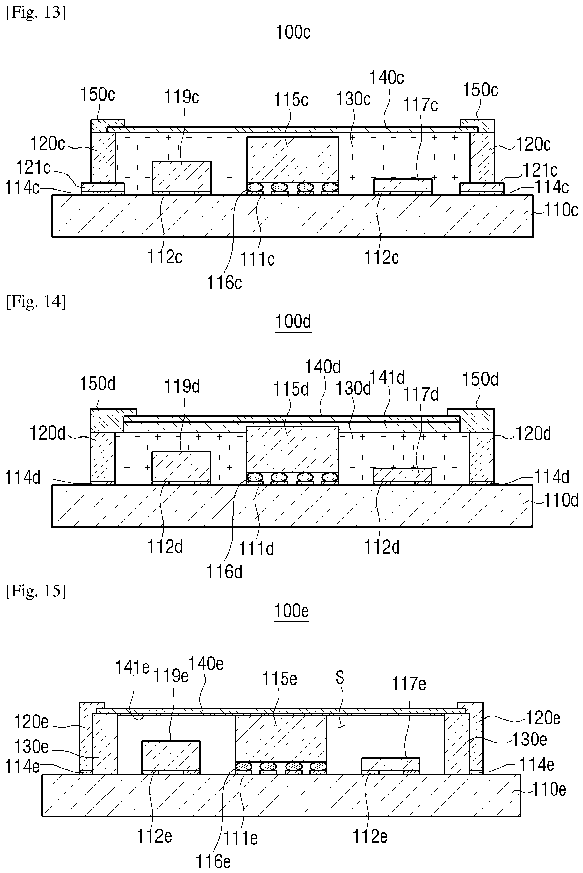

FIG. 13 is a non-claimed cross-sectional view illustrating a circuit element package 100c according to still another exemplary embodiment.

Referring to FIG. 13, in the circuit element package 100c, first and second connection pads 111c and 112c and a ground pad 114c are patterned on a printed circuit board 110c.

A semiconductor chip 115c includes a plurality of connection terminals 116c that are electrically connected to the first connection pads 111c of the printed circuit board 110c. Passive elements 117c and 119c may include at least one connection terminal that is electrically connected to the second connection pad 112c of the printed circuit board 110c. The semiconductor chip 115c and the passive elements 117c and 119c are covered by an insulating layer 130c to be isolated from a first shielding layer 120c.

On an upper surface of the ground pad 114c, a skirt portion 121c that supports the first shielding layer 120c is formed to increase the height of the first shielding layer 120c. Because the skirt portion 121c is provided, the first shielding layer 120c secures a structural stability. Further, because the height of the first shielding layer 120c is increased, the injection process of the insulating layer 130 can be facilitated, and the thickness control of the overall shielding structure can be facilitated. In this case, the skirt portion 121c may be made of the same material as the material of the first shielding layer 120c.

The first shielding layer 120c is formed on an upper surface of the skirt portion 121c, and the insulating layer 130c is formed in a region that is partitioned by the first shielding layer 120c. The insulating layer 130c may be cured after injection of a material of the insulating layer 130c.

A second shielding layer 140c is formed on the upper surface of the insulating layer 120c. The second shielding layer 140c has an area that covers the whole upper surface of the insulating layer 130c and a part of the first shielding layer 120c.

An edge bridge 150c is formed on a part of an upper surface of the first shielding layer 120c that is not occupied by the second shielding layer 140c and a peripheral portion of an upper surface of the second shielding layer 140c. The edge bridge 150c may be made of the same material as the material of the first shielding layer 120c. A ground path is extended to the second shielding layer 140c having an area that is larger than the area of the first shielding layer 120c through the edge bridge 150c to secure electrical stability.

FIG. 14 is a non-claimed cross-sectional view illustrating a circuit element package 100d according to still another exemplary embodiment.

Referring to FIG. 14, in the circuit element package 100d, first and second connection pads 111d and 112d and a ground pad 114d are patterned on a printed circuit board 110d.

A semiconductor chip 115d includes a plurality of connection terminals 116d that are electrically connected to the first connection pads 111d of the printed circuit board 110d. Passive elements 117d and 119d may include at least one connection terminal that is electrically connected to the second connection pad 112d of the printed circuit board 110d. The semiconductor chip 115d and the passive elements 117d and 119d are covered by an insulating layer 130d to be isolated from a first shielding layer 120d.

On an upper surface of the ground pad 114d, a first shielding layer 120d is formed, and the insulating layer 130d is formed in a region that is partitioned by the first shielding layer 120d. The insulating layer 130d may be cured after injection of a material of the insulating layer 130d. In this case, if the height of the first shielding layer 120d is low, the height of the insulating layer 130d may also become low, and due to this, upper ends of the semiconductor chip 115d or the passive elements 117d and 119d having high height may be exposed to project from the upper surface of the insulating layer 130d. In this case, an insulating adhesive layer 141d is formed on an upper surface of the insulating layer 130d so that the semiconductor chip 115d that is exposed from the insulating layer 130d and a second shielding layer 140d are kept in an isolation state from each other. In this case, the second shielding layer 130d may be a shielding film.

Accordingly, even in the case in which the height of the insulating layer 130d is limited due to the low height of the first shielding layer 120d and thus the semiconductor chip 115d or the passive elements 117d and 119d are exposed to an outside of the insulating layer 130d, the semiconductor chip 115d or the passive elements 117d and 119d can be prevented from being short-circuited to the second shielding layer 140d by the insulating adhesive layer 141d.

An edge bridge 150d covers the upper surface of the first shielding layer 120d, a peripheral portion of the upper surface of the insulating layer 130d, and the upper surface of the second shielding layer 140d. The edge bridge 150d may be made of the same material as the material of the first shielding layer 120d. A ground path is extended to the second shielding layer 140d having an area that is larger than the area of the first shielding layer 120d through the edge bridge 150d to secure electrical stability.

FIG. 15 is a non-claimed cross-sectional view illustrating a circuit element package 100e according to still another exemplary embodiment.

Referring to FIG. 15, in the circuit element package 100e, first and second connection pads 111e and 112e and a ground pad 114e are patterned on a printed circuit board 110e.

A semiconductor chip 115e includes a plurality of connection terminals 116e that are electrically connected to the first connection pads 111e of the printed circuit board 110e. Passive elements 117e and 119e may include at least one connection terminal that is electrically connected to the second connection pad 112e of the printed circuit board 110e.

In the circuit element package 100e, an insulating layer 130e is formed before a first shielding layer 120e is formed. In the case in which the insulating layer 130e is first formed, the first shielding layer 120e can depend on the insulating layer 130e when the first shielding layer 120e is formed on the basis of the insulating layer 130e, and thus higher aspect ratio can be achieved in comparison to a case in which the first shielding layer 120e is singly formed.

The insulating layer 130e may be formed at a predetermined height, and may be formed on the printed circuit board 110e to form a closed curve substantially in a dam shape. In this case, a predetermined space S is formed inside the insulating layer 130e.

A peripheral portion of a bottom surface of a second shielding layer 140e is laminated on an upper surface of the insulating layer 130e, and an insulating film 141e is formed on a bottom surface of the second shielding layer 140e. In this case, the height of the insulating layer 130e may be lowered to minimize the space S, and in this case, the insulating film 141e may come in contact with the upper surface of the semiconductor chip 115e.

The first shielding layer 120e is formed to surround an outer surface of the insulating layer 130e, and an upper end of the first shielding layer 120e is formed to cover a peripheral portion of an upper surface of the second shielding layer 140e so that it can be connected to the second shielding layer 140e. Accordingly, a ground path is extended to the second shielding layer 140e having an area that is larger than the area of the first shielding layer 120e through an upper end portion of the first shielding layer 120e to secure electrical stability.

As described above, in the case of forming the first shielding layer 120e on the basis of the insulating layer 130e, a large amount (equal to or lower than 70%) of metal filler is contained in the material of the first shielding layer 120e, and thus it may be applied in the case in which the improvement of thixotropy is difficult. In this case, because the insulating layer 130e is in a dam shape, an injection process of an insulating material can be omitted. Accordingly, the process can be promptly performed, and material saving effects can be obtained.

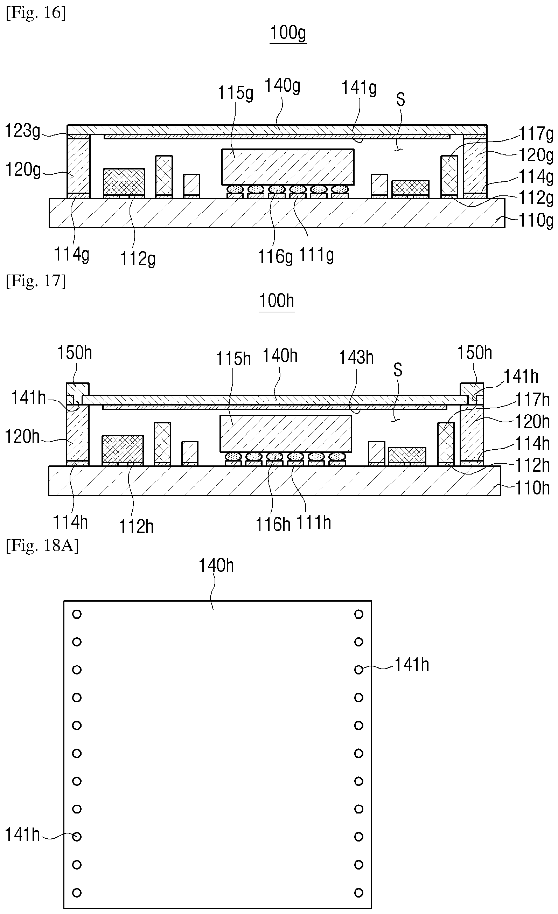

FIG. 16 is a non-claimed cross-sectional view illustrating a circuit element package 100g according to still another exemplary embodiment.

Referring to FIG. 16, in the circuit element package 100g, first and second connection pads 111g and 112g and a ground pad 114g are patterned on a printed circuit board 110g.

A semiconductor chip 115g includes a plurality of connection terminals 116g that are electrically connected to the first connection pads 111g of the printed circuit board 110g. A passive element 117g may include at least one connection terminal that is electrically connected to the second connection pad 112g of the printed circuit board 110g. The semiconductor chip 115g and the passive element 117g may be isolated from first and second shielding layers 120g and 140g by a predetermined space S formed inside the first shielding layer 120g.

On an upper surface of the ground pad 114g, the first shielding layer 120g is formed. The second shielding layer 140g may be a shielding film, and an insulating film 141g and a conductive adhesive layer 123g that surrounds the insulating film 141g are formed on a bottom surface of the second shielding layer 140g. A ground path is extended to the second shielding layer 140g having an area that is larger than the area of the first shielding layer 120g through the conductive adhesive layer 123g to secure electrical stability.

When the second shielding layer 140g is attached to the upper surface of the first shielding layer 120g through the adhesive layer 123g, the insulating film 141g covers upper surfaces of the semiconductor chip 115g and the passive element 117g. Accordingly, the insulating film 141g can prevent the second shielding layer 140g from being short-circuited to the semiconductor chip 115g and the passive element 117g.

In this case, because a separate insulating layer except for the insulating film 141g can be omitted, the process can be promptly performed, and material saving effects can be obtained.

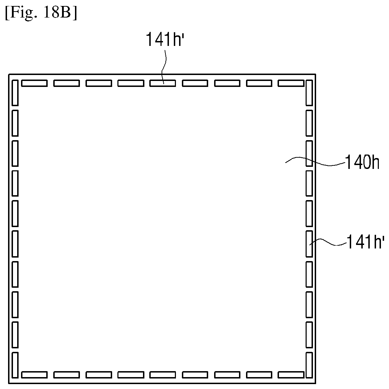

FIG. 17 is a non-claimed cross-sectional view illustrating a circuit element package 100h according to still another exemplary embodiment, and FIGS. 18A and 18B are plan views illustrating a second shielding layer 140h according to exemplary non-claimed embodiments.

Referring to FIG. 17, in the circuit element package 100h, first and second connection pads 111h and 112h and a ground pad 114h are patterned on a printed circuit board 110h.

A semiconductor chip 115h includes a plurality of connection terminals 116h that are electrically connected to the first connection pads 111h of the printed circuit board 110h. A passive element 117h may include at least one connection terminal that is electrically connected to the second connection pad 112h of the printed circuit board 110h. The semiconductor chip 115h and the passive element 117h may be isolated from first and second shielding layers 120h and 140h by a predetermined space S formed inside the first shielding layer 120h.

On an upper surface of the ground pad 114h, the first shielding layer 120h is formed. The second shielding layer 140h may be a shielding film, and an insulating film 143h is formed on a bottom surface of the second shielding layer 140h. When the second shielding layer 140h is attached to the upper surface of the first shielding layer 120h through a connection layer 150h, the insulating film 143h covers upper surfaces of the semiconductor chip 115h and the passive element 117h. Accordingly, the insulating film 143h can prevent the second shielding layer 140h from being short-circuited to the semiconductor chip 115h and the passive element 117h.

Referring to non-claimed FIG. 18A, a plurality of through-holes 141h are formed at predetermined intervals along peripheral portions of both sides thereof. The peripheral portions of both sides of the second shielding layer 140h may be seated on the upper surface of the first shielding layer 120h, and the connection layer 150h that is made of a conductive shielding material, such as an edge bridge, may be formed along the peripheral portion of the upper surface of the second shielding layer 140h. In this case, the connection layer 150h that is spread on the first shielding layer 140h may flow into the plurality of through-holes 141h to electrically connect the first and second shielding layers 120h and 140h to each other. Accordingly, a ground path is extended to the second shielding layer 140h having an area that is larger than the area of the first shielding layer 120h through the connection layer 141h to secure electrical stability.

Referring to non-claimed FIG. 18B, a plurality of through-holes 141h' are formed at predetermined intervals along four sides of the second shielding layer 140h. In the case in which the second shielding layer has four or more sides, the plurality of through-holes may be formed to correspond to the respective sides.

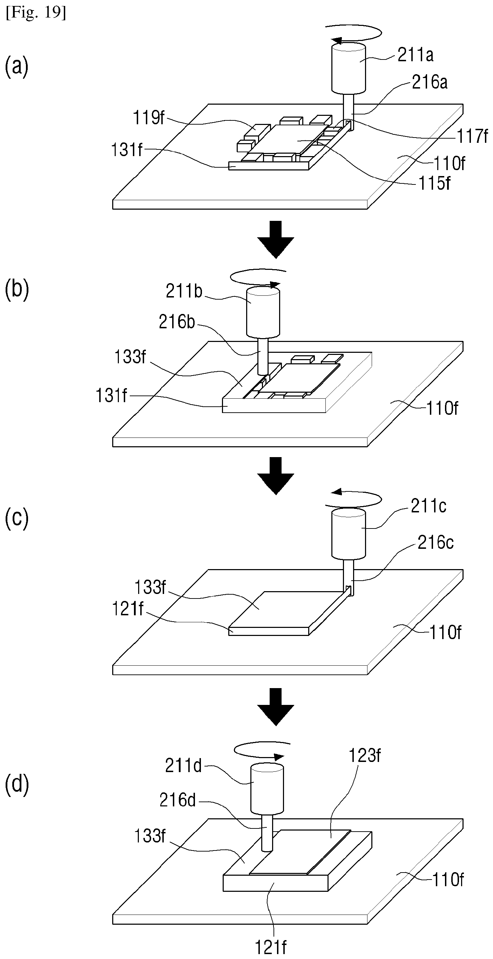

FIG. 19 is a non-claimed view successively illustrating a process of manufacturing a circuit element package according to still another exemplary embodiment. Referring to portion (a) of FIG. 19, a first insulating layer 131f is formed in a dam shape on an upper surface of a printed circuit board 110f to surround a semiconductor chip 115f and passive elements 117f and 119f that are mounted on the printed circuit board 110f using a dispenser including a storage chamber 211a and a nozzle 216a. The first insulating layer 131f may be formed at a height having a predetermined aspect ratio.

Referring to portion (b) of FIG. 19, a second insulating layer 133f is formed by injecting an insulating material into the first insulating layer 131f using another dispenser including a storage chamber 2211b and a nozzle 216b. The first insulating layer 131f forms a side surface of the insulating layer, and the second insulating layer 133f forms an upper surface of the insulating layer.

Because a material of the second insulating layer 133f has a viscosity that is lower than the viscosity of a material of the first insulating layer 131f, the second insulating layer 133f has fluidity that is higher than the fluidity of the first insulating layer 13 1f. Accordingly, an insulating material that is injected from the nozzle 216b to the inside of the first insulating layer 131f can completely fill a gap between the semiconductor chip 115f and the passive elements 117f and 119f and the printed circuit board 110f. If the injection is completed, the second insulating layer 133f is cured to have a predetermined hardness.

Referring to portion (c) of FIG. 19, a first shielding layer 121f is formed to surround the first insulating layer 131f using still another dispenser including a storage chamber 211c and a nozzle 216c. In this case, because the first shielding layer 121f is formed depending on the first insulating layer 131f, the first shielding layer 121f may be formed with a higher height than the height in the case in which the first shielding layer 121f is singly formed.

Referring to portion (d) of FIG. 19, a second shielding layer 123f is spread on the upper surface of the second insulating layer 133f using still another dispenser including a storage chamber 211d and a nozzle 216d. In this case, the second shielding layer 123f may be spread to be electrically connected to the first insulating layer 121f, and thus a ground path is extended from the first insulating layer 121f connected to a ground pad to the second shielding layer 123f to secure electrical stability.

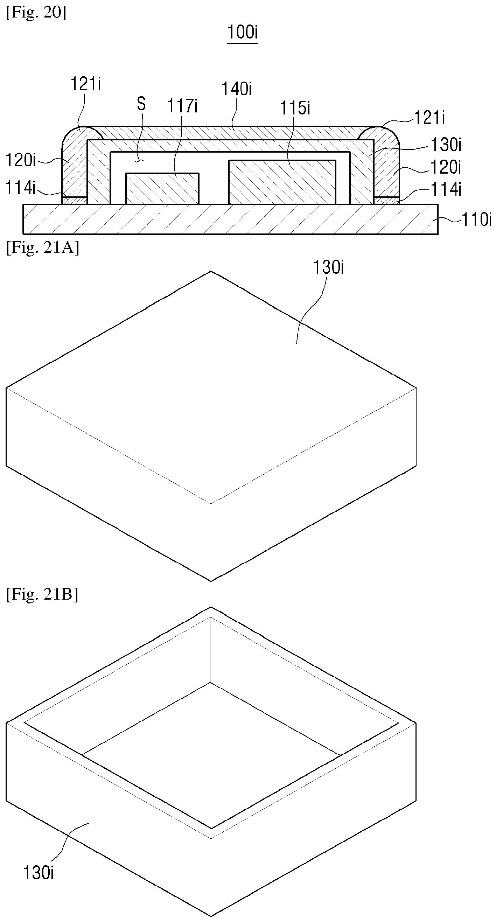

FIG. 20 is a non-claimed cross-sectional view illustrating a circuit element package 100i according to still another exemplary embodiment, and FIGS. 21A and 21B are perspective views illustrating an upper portion and a lower portion of an insulating mold 130i illustrated in FIG. 20.

Referring to FIG. 20, in the circuit element package 100i, first and second connection pads and a ground pad 114i may be patterned on a printed circuit board 110i.

A semiconductor chip 115i may include a plurality of connection terminals that are electrically connected to the first connection pad of the printed circuit board 110i. A passive element 117i may include at least one connection terminal that is electrically connected to the second connection pad of the printed circuit board 110i. The semiconductor chip 115i and the passive element 117i may be isolated from first and second shielding layers 120i and 140i by an insulating layer 130i of a first shielding layer 120i.

A plurality of connection terminals of the first and second connection pads, the ground pad, and the semiconductor chip 115i may be provided in the same manner as the first and second connection pads 111 and 112, the ground pad 114, and the plurality of connection terminals 116 as illustrated in FIG. 1.

Referring to FIGS. 21A and 21B, the insulating layer 130i of the circuit element package 100i may not be formed by injecting a material using a dispenser, but the insulating mold 130i that is in a box shape having an open bottom surface may be applied to the circuit element package 100i.

Referring again to FIG. 20, the insulating mold 130i is seated on the printed circuit board 110i so that the open bottom surface thereof is directed toward the printed circuit board 110i. In this case, the semiconductor chip 115i and the passive element 117i are positioned in an inner space S of the insulating mold 130i.

The first shielding layer 120i is laminated on the upper surface of the ground pad 114i, and is formed along the periphery of the insulating mold 130i based on the side surface of the insulating mold 130i. In this case, because the first shielding layer 120i is formed depending on the insulating mold 130i, the first shielding layer 120i may be formed with a higher height that the height in the case in which the first shielding layer 120i is singly formed.

In this case, the first shielding layer 120i is formed so that an upper end portion 121i of the first shielding layer 120i reaches the peripheral portion of the upper surface of the insulating mold 130i. Accordingly, the upper end portion 121i of the first shielding layer 120i is formed to be higher than the upper surface of the insulating mold 130i to serve as a dam.

On the upper surface of the insulating mold 130i, the second shielding layer 140i is formed on the inside of the upper end portion 121i of the first shielding layer 120i. The second shielding layer 140i may be formed in a manner that a material that is injected through a dispenser fills the inside of the upper end portion 121i of the first shielding layer 120i. In this case, because the second shielding layer 140i is formed in a state in which it is naturally connected to the first shielding layer 120i, a ground path is extended from the first shielding layer 120i to the second insulating layer 140i to secure electrical stability.

As described above, because the circuit element package 100i does not form the insulating layer through injection of the insulating material through the dispenser, but forms the insulating layer using the prepared insulating mold 130i, the process of injecting the insulating layer through the dispenser and curing the injected insulating layer can be omitted, and thus the production yield can be reduced to greatly shorten the production time.

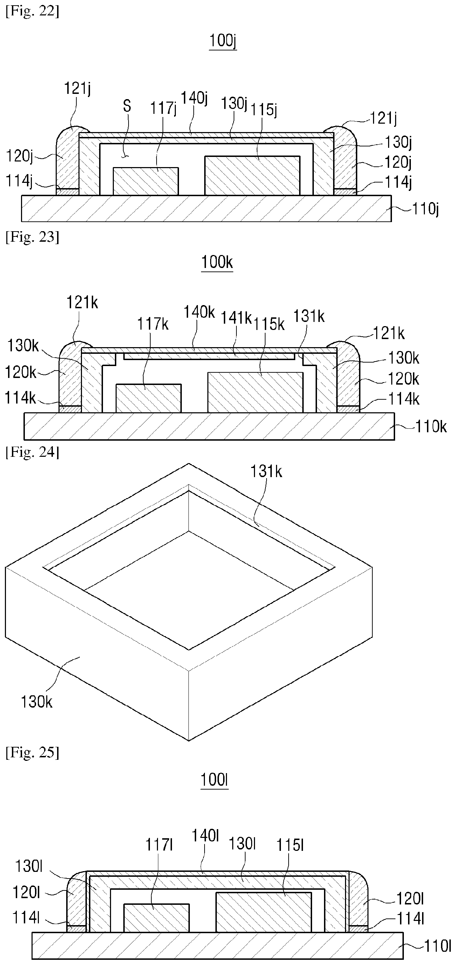

FIG. 22 is a non-claimed cross-sectional view illustrating a circuit element package 100j according to still another exemplary embodiment.

Referring to FIG. 22, in the circuit element package 100j, first and second connection pads and a ground pad 114j may be patterned on a printed circuit board 110j.

A semiconductor chip 115j may include a plurality of connection terminals that are electrically connected to the first connection pad of the printed circuit board 110j.

A passive element 117j may include at least one connection terminal that is electrically connected to the second connection pad of the printed circuit board 110j. The semiconductor chip 115j and the passive element 117j may be isolated from first and second shielding layers 120j and 140j by an insulating layer 130j of the first shielding layer 120j.

A plurality of connection terminals of the first and second connection pads, the ground pad, and the semiconductor chip 115j may be provided in the same manner as the first and second connection pads 111 and 112, the ground pad 114, and the plurality of connection terminals 116 as illustrated in FIG. 1.

The insulating layer 130j of the circuit element package 100j may be formed by applying an insulating mold 130j that is in a box shape having an open bottom surface in the same manner as the circuit element package 100i as described above. The insulating mold 130j is seated on the printed circuit board 110j so that the open bottom surface thereof is directed toward the printed circuit board 1 10j. In this case, the semiconductor chip 115j and the passive element 117j are positioned in an inner space S of the insulating mold 130j.

On the upper surface of the insulating mold 130j, the second shielding layer 140j is formed. In this case, the second shielding layer 140j may be a shielding film, and an adhesive layer may be formed on a bottom surface of the shielding film so that the shielding film can be attached to the upper surface of the insulating mold 130j.

The first shielding layer 120j is laminated on the upper surface of the ground pad 114j, and is formed along the periphery of the insulating mold 130j based on the side surface of the insulating mold 130j. In this case, because the first shielding layer 120j is formed depending on the insulating mold 130j, the first shielding layer 120j may be formed with a higher height than the height in the case in which the first shielding layer 120j is singly formed. An upper end portion 121j of the first shielding layer 120j is formed up to the peripheral portion of the upper surface of the second shielding layer 140j. Accordingly, the second shielding layer 140j is naturally connected to the first shielding layer 120j, and thus a ground path is extended from the first shielding layer 120j to the second shielding layer 140j to secure electrical stability.

As described above, because the circuit element package 100j uses the prepared insulating mold 130j, the process of injecting the insulating layer through the dispenser and curing the injected insulating layer can be omitted, and thus the production yield can be reduced to greatly shorten the production time.

FIG. 23 is a non-claimed cross-sectional view illustrating a circuit element package 100k according to still another exemplary embodiment, and FIG. 24 is a perspective view illustrating an insulating mold 130k illustrated in FIG. 23.

Referring to FIG. 23, in the circuit element package 100k, first and second connection pads and a ground pad 114k may be patterned on a printed circuit board 110k.

A semiconductor chip 115k may include a plurality of connection terminals that are electrically connected to the first connection pad of the printed circuit board 110k. A passive element 117k may include at least one connection terminal that is electrically connected to the second connection pad of the printed circuit board 110k. The semiconductor chip 115k and the passive element 117k may be isolated from first and second shielding layers 120k and 140k by an insulating layer 130k of the first shielding layer 120k.

A plurality of connection terminals of the first and second connection pads, the ground pad, and the semiconductor chip 115k may be provided in the same manner as the first and second connection pads 111 and 112, the ground pad 114, and the plurality of connection terminals 116 as illustrated in FIG. 1.

Referring to non-claimed FIG. 24, the insulating layer 130k of the circuit element package 100k may be formed by applying the insulating mold 130k that is substantially in a rectangular frame shape having open bottom and upper surfaces.

Referring again to FIG. 23, the insulating mold 130k is seated on the printed circuit board 110k so that the open bottom surface thereof is directed toward the printed circuit board 110k. In this case, the semiconductor chip 115k and the passive element 117k are positioned in an inner space of the insulating mold 130k.

On a peripheral portion of an upper surface of the insulating mold 130k, a second shielding layer 140k is seated. In this case, an adhesive layer may be formed on a peripheral portion of a bottom surface of the second shielding layer 140k to improve a bonding force with the insulating mold 130k.

The second shielding layer 140k may be a shielding film, and an adhesive layer may be formed on a bottom surface of the shielding film so that the shielding film can be attached to the upper surface of the insulating mold 130k. The second shielding layer 140k closes an opening 131k that is formed on the upper surface of the insulating mold 130k. In this case, an insulating film 141k having an area that corresponds to or is somewhat smaller than an area of the opening 131k is formed on a bottom surface of the second shielding layer 140k. The insulating film 141k covers upper portions of the semiconductor chip 115 and the passive element 117k. Accordingly, the insulating film 141k can prevent the second shielding layer 140k from being short-circuited to the semiconductor chip 115k and the passive element 117k.

The first shielding layer 120k is laminated on the upper surface of the ground pad 114k, and is formed along the periphery of the insulating mold 130k based on the side surface of the insulating mold 130k. In this case, because the first shielding layer 120k is formed depending on the insulating mold 130k, the first shielding layer 120k may be formed with a higher height than the height in the case in which the first shielding layer 120k is singly formed. An upper end portion 121k of the first shielding layer 120k is formed up to the peripheral portion of the upper surface of the second shielding layer 140k. Accordingly, the second shielding layer 140k is naturally connected to the first shielding layer 120k, and thus a ground path is extended from the first shielding layer 120k to the second shielding layer 140k to secure electrical stability.

As described above, because the circuit element package 100k uses the prepared insulating mold 130k, the process of injecting the insulating layer through the dispenser and curing the injected insulating layer can be omitted, and thus the production yield can be reduced to greatly shorten the production time.

FIG. 25 is a non-claimed cross-sectional view illustrating a circuit element package 100l according to still another exemplary embodiment.

Referring to FIG. 25, in the circuit element package 100l, first and second connection pads and a ground pad 114l may be patterned on a printed circuit board 110l.

A semiconductor chip 115l may include a plurality of connection terminals that are electrically connected to the first connection pad of the printed circuit board 110l.

A passive element 117l may include at least one connection terminal that is electrically connected to the second connection pad of the printed circuit board 110l. The semiconductor chip 115l and the passive element 117l may be isolated from first and second shielding layers 120l and 140l by an insulating layer 130l of the first shielding layer 120l.

A plurality of connection terminals of the first and second connection pads, the ground pad, and the semiconductor chip 115l may be provided in the same manner as the first and second connection pads 111 and 112, the ground pad 114, and the plurality of connection terminals 116 as illustrated in FIG. 1.

The insulating layer 130l of the circuit element package 100l may be formed by applying an insulating mold 130l that is in a box shape having an open bottom surface in the same manner as the circuit element package 100i as described above. The insulating mold 130l is seated on the printed circuit board 130l so that the open bottom surface thereof is directed toward the printed circuit board 110l. In this case, the semiconductor chip 115l and the passive element 117l are positioned in an inner space S of the insulating mold 130l.

On an outer surface, i.e., a side surface and an upper surface, of the insulating mold 130l, the second shielding layer 140l is formed. The second shielding layer 140l may be coated together on the outer surface of the insulating mold 130l during manufacturing of the insulating mold 1301.

The first shielding layer 120l is laminated on the upper surface of the ground pad 114l, and is formed along the periphery of the insulating mold 130l based on the side surface of the insulating mold 130l. In this case, the first shielding layer 120l is formed with a height that is not higher than the height of the insulating mold 130l.

That is, the first shielding layer 120l is formed so that the height thereof substantially corresponds to the height of the insulating mold 130l.

Because the second shielding layer 140l is naturally connected to the first shielding layer 120l, a ground path is extended from the first shielding layer 120l to the second shielding layer 140l to secure electrical stability.

As described above, because the circuit element package 100l uses the prepared insulating mold 130l and the second shielding layer 140l is also pre-coated on the outer surface of the insulating mold 130l, the process of injecting the insulating layer and the second shielding layer through the dispenser and curing the injected layers can be omitted, and thus the production yield and the production time can be greatly reduced.

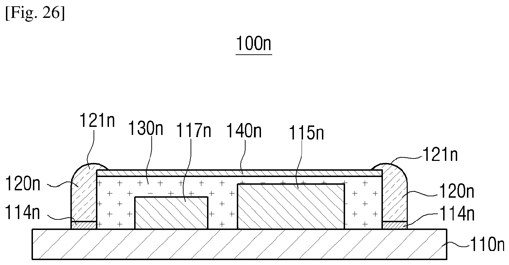

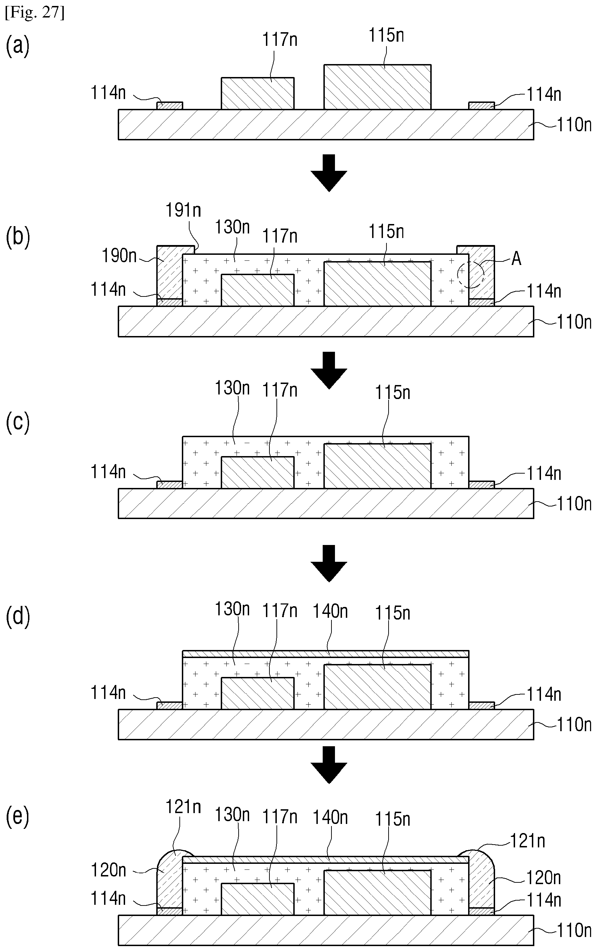

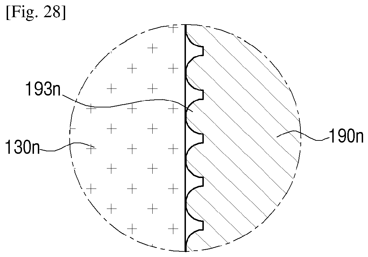

FIG. 26 is a non-claimed cross-sectional view illustrating a circuit element package 100n according to still another exemplary embodiment. FIG. 27 is a view illustrating a process of manufacturing the circuit element package 100n illustrated in FIG. 26, according to still another exemplary non-claimed embodiment, and FIG. 28 is an enlarged view illustrating portion "A" in FIG. 27.

Referring to FIG. 26, in the circuit element package 100n, first and second connection pads and a ground pad 114n may be patterned on a printed circuit board 110n.

A semiconductor chip 115n may include a plurality of connection terminals that are electrically connected to the first connection pad of the printed circuit board 110n. A passive element 117n may include at least one connection terminal that is electrically connected to the second connection pad of the printed circuit board 110n. The semiconductor chip 115n and the passive element 117n may be isolated from first and second shielding layers 120n and 140n by an insulating layer 130n of the first shielding layer 120n.

A plurality of connection terminals of the first and second connection pads, the ground pad, and the semiconductor chip 115n may be provided in the same manner as the first and second connection pads 111 and 112, the ground pad 114, and the plurality of connection terminals 116 as illustrated in FIG. 1.

The insulating layer 130n of the circuit element package 100n is formed using a separate mold 190n before the first shielding layer 120n is formed, as illustrated in non-claimed FIG. 27.

Referring to portion (a) of FIG. 27, connection pads and the ground pad 114n are patterned on an upper surface of the printed circuit board 110n, and then the semiconductor chip 115n and the passive element 117n are bonded to be electrically connected to the connection pads.

Referring to portion (b) of FIG. 27, the mold 190n with an upper end portion 191n is seated on an upper surface of the ground pad 114n, and then an insulating material is injected into the mold 190n to form the insulating layer 130n. The insulating layer 130n may be cured to have a predetermined hardness through a curing process after being injected into the mold 190n.

Referring to portion (c) of FIG. 27, after the insulating layer 130n is cured, the mold 190n is separated from the insulating layer 130n. In this case, as shown in non-claimed FIG. 28, the mold 190n may be made of a super hydrophobic metal on which a plurality of micro-projections 193n are inwardly formed so that the mold 190n can be easily separated from the insulating layer 130n.

Referring to portion (d) of FIG. 27, the second shielding layer 140n is formed on the upper surface of the cured insulating layer 130n. The second shielding layer 140n may be a shielding film having a predetermined thickness, and may have an area that is substantially equal to the area of the upper surface of the insulating layer 130n. In this case, because adhesives are spread on the bottom surface of the second shielding layer 140n, the second shielding layer 140n may be attached to the upper surface of the insulating layer 130n.

Referring to portion (e) of FIG. 27, because the first shielding layer 120n is formed depending on the insulating layer 130n, an upper end portion 121n of the first shielding layer 120n is formed up to the peripheral portion of the upper surface of the second shielding layer 140n. Accordingly, the second shielding layer 140n is naturally connected to the first shielding layer 120n, and thus a ground path is extended from the first shielding layer 120n to the second shielding layer 140n to secure electrical stability.

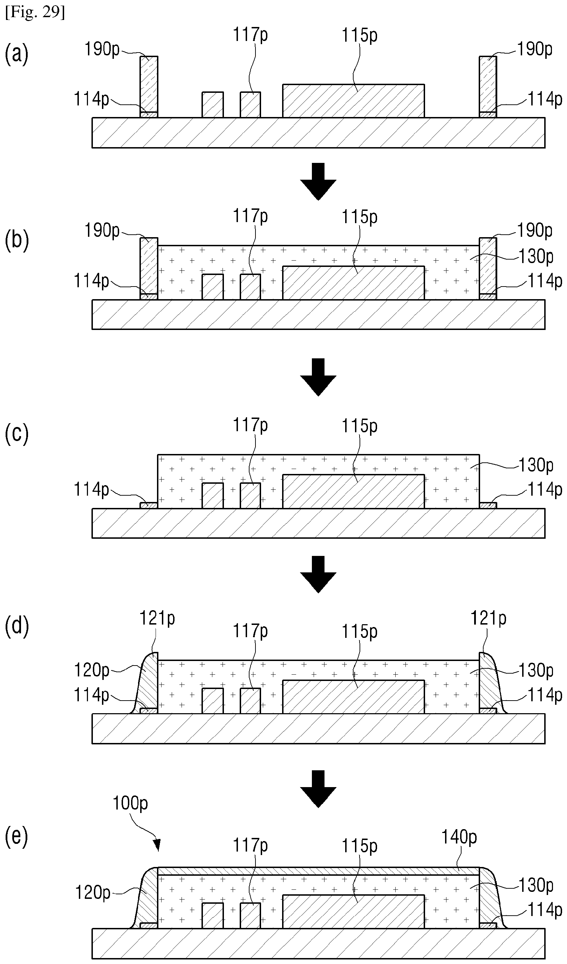

FIG. 29 is a non-claimed view illustrating a process of manufacturing a circuit element package 100p according to still another exemplary embodiment.

Referring to portion (e) of FIG. 29, in the circuit element package 100p, first and second connection pads and a ground pad 114p may be patterned on a printed circuit board 110p.

A semiconductor chip 115p may include a plurality of connection terminals that are electrically connected to the first connection pad of the printed circuit board 110p. A passive element 117p may include at least one connection terminal that is electrically connected to the second connection pad of the printed circuit board 110p. The semiconductor chip 115p and the passive element 117p may be isolated from first and second shielding layers 120p and 140p by an insulating layer 130p of the first shielding layer 120p.

A plurality of connection terminals of the first and second connection pads, the ground pad, and the semiconductor chip 115p may be provided in the same manner as the first and second connection pads 111 and 112, the ground pad 114, and the plurality of connection terminals 116 as illustrated in FIG. 1.

A process of manufacturing the circuit element package 100p is as follows.

Referring to portion (a) of FIG. 29, the connection pads and the ground pad 114p are patterned on an upper surface of the printed circuit board 110p, and then the semiconductor chip 115p and the passive element 117p are bonded to be electrically connected to the connection pads. A mold 190p is seated on an upper surface of the ground pad 114p.

Referring to portion (b) of FIG. 29, an insulating material is injected into the mold 190p to form the insulating layer 130p. The insulating layer 130p may be cured to have a predetermined hardness through a curing process after being injected into the mold 190p.

Referring to portion (c) of FIG. 29, after the insulating layer 130p is cured, the mold 190p is separated from the insulating layer 130p. In this case, the mold 190p may be made of a super hydrophobic metal on which the plurality of micro-projections 193n (of FIG. 28) are inwardly formed so that the mold 190p can be easily separated from the insulating layer 130p.

Referring to portion (d) of FIG. 29, the first shielding layer 120p is formed along the outline of the insulating layer 130p. In this case, because the first shielding layer 120p is formed depending on the insulating layer 130p, the first shielding layer 120p is formed at high height. Accordingly, an upper end portion 121p of the first shielding layer 120p is formed to be higher than the upper surface of the insulating layer 130p.

Referring again to portion (e) of FIG. 29, a material that forms the second shielding layer 140p is injected into a space that is inwardly formed in the upper end portion 121p of the first shielding layer 120p to be cured. As described above, the second shielding layer 140p that is formed on the upper surface of the insulating layer 130p is electrically connected to the upper end portion 121p of the first shielding layer 120p. Accordingly, a ground path is extended from the first shielding layer 120p to the second shielding layer 140p to secure electrical stability.

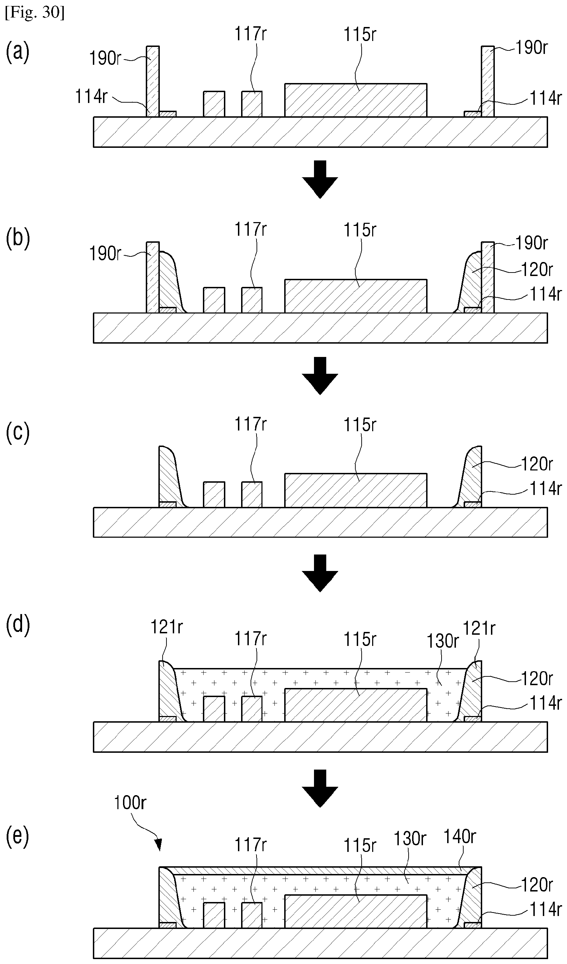

FIG. 30 is a non-claimed view illustrating a process of manufacturing a circuit element package 100r according to still another exemplary embodiment.

Referring to portion (e) of FIG. 30, in the circuit element package 100r, first and second connection pads and a ground pad 114r may be patterned on a printed circuit board 110r.

A semiconductor chip 115r may include a plurality of connection terminals that are electrically connected to the first connection pad of the printed circuit board 110r. A passive element 117r may include at least one connection terminal that is electrically connected to the second connection pad of the printed circuit board 110r. The semiconductor chip 115r and the passive element 117r may be isolated from first and second shielding layers 120r and 140r by an insulating layer 130r of the first shielding layer 120r.

A plurality of connection terminals of the first and second connection pads, the ground pad, and the semiconductor chip 115r may be provided in the same manner as the first and second connection pads 111 and 112, the ground pad 114, and the plurality of connection terminals 116 as illustrated in FIG. 1.

A process of manufacturing the circuit element package 100r is as follows.

Referring to portion (a) of FIG. 30, the connection pads and the ground pad 114r are patterned on an upper surface of the printed circuit board 110r, and then the semiconductor chip 115r and the passive element 117r are bonded to be electrically connected to the connection pads. Further, a mold 190r is seated on an upper surface of the printed circuit board 110r so that the mold 190r is arranged on an outside of the ground pad 114r.

Referring to portion (b) of FIG. 30, the first shielding layer 120r is formed along an inner surface of the mold 190r, and in this case, the first shielding layer 120r is formed on an upper surface of the ground pad 114r. As described above, the first shielding layer 120r is formed at a high height because the first shielding layer 120r is formed depending on the mold 190r.

Referring to portion (c) of FIG. 30, after the first shielding layer 120r is cured, the mold 190r is separated from the first shielding layer 120r. In this case, the mold 190r may be made of a super hydrophobic metal on which the plurality of micro-projections 193n (of FIG. 28) are inwardly formed so that the mold 190r can be easily separated from the first shielding layer 120r.

Referring to portion (d) of FIG. 30, the insulating layer 130r is cured by injecting an insulating material into a space that is formed inside the first shielding layer 120r. In this case, the insulating layer 130r is injected up to a height enough to have a predetermined space inside an upper end portion 121r of the first shielding layer 120r to form the second shielding layer 140r that is to be formed on the upper surface of the insulating layer 130r later.

Referring to portion (e) of FIG. 30, a material that forms the second shielding layer 140r is injected into a space that is inwardly formed in the upper end portion 121r of the first shielding layer 120r to be cured. As described above, the second shielding layer 140r that is formed on the upper surface of the insulating layer 130r is electrically connected to the upper end portion 121r of the first shielding layer 120r. Accordingly, a ground path is extended from the first shielding layer 120r to the second shielding layer 140r to secure electrical stability.

## Industrial Applicability

Apparatuses and methods consistent with exemplary embodiments relate to a circuit element package, a manufacturing method thereof.

## Claims

1.  A circuit element package (100) comprising:

    at least one circuit element (115) mounted on a printed circuit board (110),
    an insulating layer (130) covering the at least one circuit element (115) and an upper surface of the printed circuit board (110); and
    an electromagnetic shielding layer (120, 140) covering the insulating layer (130),
    wherein the electromagnetic shielding layer includes a first electromagnetic shielding layer (120) covering a side surface of the insulating layer (130), and a second electromagnetic shielding layer (140) covering an upper surface of the insulating layer (130),
    the circuit element package (100) further comprises an edge bridge (150), disposed between the first electromagnetic shielding layer (120) and the second electromagnetic shielding layer (140) to cover a boundary between the first electromagnetic shielding layer (120) and the insulating layer (130) and the periphery thereof and a peripheral portion of the upper surface of the insulating layer and laminated on the upper surface of the first electromagnetic shielding layer (120), wherein the second electromagnetic shielding layer (140) is further covering an upper surface of the edge bridge (150) and wherein the edge bridge (150) is electrically connecting the first electromagnetic shielding layer (120) and the second electromagnetic shielding layer (140); and

the circuit element (115) is a semiconductor chip connected to the printed circuit board (110) by connection terminals (116) and respective connection pads (111) on the upper surface of the printed circuit board (110).

2. A method for manufacturing a circuit element package, comprising:

mounting a circuit element (115) on a printed circuit board (110) wherein the circuit element (115) is a semiconductor chip connected to the printed circuit board (110) by connection terminals (116) and respective connection pads (111) on an upper surface of the printed circuit board (110);

forming a first electromagnetic shielding layer (120) on the printed circuit board (110) to form a dam;

forming an insulating layer (130) on the inside of the first electromagnetic shielding layer (120) to cover the circuit element (115) and the upper surface of the printed circuit board;and wherein the insulating layer (130) is injected into the first electromagnetic shielding layer (120) and then cured after the first electromagnetic shielding layer is formed,

forming an edge bridge (150) to cover a boundary between the first electromagnetic shielding layer (120) and the insulating layer (130) and the periphery thereof on an upper surface of the first electromagnetic shielding layer (120) and a peripheral portion of an upper surface of the insulating layer (130); and

forming a second electromagnetic shielding layer (140) to cover the upper surface of the insulating layer (130) and an upper surface of the edge bridge (150),

wherein the first electromagnetic shielding layer (120) is covering a side surface of the insulating layer (130),

wherein the edge bridge (150) is electrically connecting the first electromagnetic shielding layer (120) and the second electromagnetic shielding layer (140) to each other.

3. The method according to claim 2, wherein at the time of the injecting of the insulating layer (130), the first electromagnetic shielding layer (120) comprises an electromagnetic shielding material having a viscosity higher than a viscosity of the insulating layer (130).

## Patentansprüche

1. Schaltungselementgehäuse (100), das Folgendes umfasst:

mindestens ein Schaltungselement (115), das auf einer Leiterplatte (110) montiert ist, eine Isolierschicht (130), die das mindestens eine Schaltungselement (115) und eine Oberseite der Leiterplatte (110) bedeckt; und eine elektromagnetische Abschirmungsschicht (120, 140), die die Isolierschicht (130) bedeckt, wobei die elektromagnetische Abschirmungsschicht eine erste elektromagnetische Abschirmungsschicht (120), die eine Seitenfläche der Isolierschicht (130) bedeckt, und eine zweite elektromagnetische Abschirmungsschicht (140), die eine Oberseite der Isolierschicht (130) bedeckt, umfasst, das Schaltungselementgehäuse (100) ferner eine Randbrücke (150) umfasst, die zwischen der ersten elektromagnetischen Abschirmungsschicht (120) und der zweiten elektromagnetischen Abschirmungsschicht (140) angeordnet ist, um eine Grenze zwischen der ersten elektromagnetischen Abschirmungsschicht (120) und der Isolierschicht (130) und deren Umfang und einen Umfangsabschnitt der Oberseite der Isolierschicht abzudecken, und auf die Oberseite der ersten elektromagnetischen Abschirmungsschicht (120) laminiert ist, wobei die zweite elektromagnetische Abschirmungsschicht (140) ferner eine Oberseite der Randbrücke (150) bedeckt und wobei die Randbrücke (150) die erste elektromagnetische Abschirmungsschicht (120) und die zweite elektromagnetische Abschirmungsschicht (140) elektrisch verbindet; und das Schaltungselement (115) ein Halbleiterchip ist, der mit der Leiterplatte (110) durch Verbindungsanschlüsse (116) und entsprechende Verbindungspads (111) auf der Oberseite der Leiterplatte (110) verbunden ist.

2. Verfahren zur Herstellung eines Schaltungselementgehäuses, umfassend:

Anbringen eines Schaltungselements (115) auf einer Leiterplatte (110), wobei das Schaltungselement (115) ein Halbleiterchip ist, der mit der Leiterplatte (110) durch Verbindungsanschlüsse (116) und jeweilige Verbindungspads (111) auf einer Oberseite der Leiterplatte (110) verbunden ist;

Ausbilden einer ersten elektromagnetischen Abschirmungsschicht (120) auf der Leiterplatte (110), um einen Damm zu bilden;

Ausbilden einer Isolierschicht (130) auf der Innenseite der ersten elektromagnetischen Abschirmungsschicht (120), um das Schaltungselement (115) und die Oberseite der Leiterplatte abzudecken; und wobei die Isolierschicht (130) in die erste elektromagnetische Abschirmungsschicht (120) eingespritzt und dann ausgehärtet wird, nachdem die erste elektromagnetische Abschirmungsschicht ausgebildet ist,

Ausbilden einer Randbrücke (150), um eine Grenze zwischen der ersten elektromagnetischen Abschirmungsschicht (120) und der Isolierschicht (130) und deren Umfang auf einer Oberseite der ersten elektromagnetischen Abschirmungsschicht (120) und einem Umfangsabschnitt einer Oberseite der Isolierschicht (130) abzudecken; und

Ausbilden einer zweiten elektromagnetischen Abschirmungsschicht (140), um die Oberseite der Isolierschicht (130) und eine Oberseite der Randbrücke (150) abzudecken,

wobei die erste elektromagnetische Abschirmungsschicht (120) eine Seitenfläche der Isolierschicht (130) bedeckt,

wobei die Randbrücke (150) die erste elektromagnetische Abschirmungsschicht (120) und die zweite elektromagnetische Abschirmungsschicht (140) elektrisch miteinander verbindet.

3. Verfahren nach Anspruch 2, wobei zum Zeitpunkt des Einspritzens der Isolierschicht (130) die erste elektromagnetische Abschirmungsschicht (120) ein elektromagnetisches Abschirmungsmaterial mit einer höheren Viskosität als die Viskosität der Isolierschicht (130) aufweist.


**Revendications**

1. Boîtier d'élément de circuit (100), comprenant :

au moins un élément de circuit (115) monté sur une carte de circuit imprimé (110),
une couche isolante (130) recouvrant l'au moins un élément de circuit (115) et une surface supérieure de la carte de circuit imprimé (110) ; et
une couche de blindage électromagnétique (120, 140) recouvrant la couche isolante (130),
dans lequel la couche de blindage électromagnétique comprend une première couche de blindage électromagnétique (120) recouvrant une surface latérale de la couche isolante (130),
et une deuxième couche de blindage électromagnétique (140) recouvrant une surface supérieure de la couche isolante (130),
dans lequel le boîtier d'élément de circuit (100) comprend en outre un pont de bord (150), disposé entre la première couche de blindage électromagnétique (120) et la deuxième couche de blindage électromagnétique (140) pour couvrir une limite entre la première couche de blindage électromagnétique (120) et la couche isolante (130) et la périphérie de celle-ci et une partie périphérique de la surface supérieure de la couche isolante et stratifiée sur la surface supérieure de la première couche de blindage électromagnétique (120), dans lequel la deuxième couche de blindage électromagnétique (140) recouvre en outre une surface supérieure du pont de bord (150) et dans lequel le pont de bord (150) relie électriquement la première couche de blindage électromagnétique (120) et la deuxième couche de blindage électromagnétique (140) ; et

l'élément de circuit (115) est une puce semi-conductrice connectée à la carte de circuit imprimé (110) par des bornes de connexion (116) et des plages de connexion (111) respectives sur la surface supérieure de la carte de circuit imprimé (110).

2. Procédé de fabrication d'un boîtier d'élément de circuit, comprenant :

monter un élément de circuit (115) sur une carte de circuit imprimé (110) l'élément de circuit (115) étant une puce semi-conductrice connectée à la carte de circuit imprimé (110) par des bornes de connexion (116) et des plages de connexion (111) respectives sur une surface supérieure de la carte de circuit imprimé (110) ;
former une première couche de blindage électromagnétique (120) sur la carte de circuit imprimé (110) pour former un barrage ;
former une couche isolante (130) à l'intérieur de la première couche de blindage électromagnétique (120) pour couvrir l'élément de circuit (115) et la surface supérieure de la carte de circuit imprimé ; et la couche isolante (130) étant injectée dans la première couche de blindage électromagnétique (120) et ensuite durcie après la formation de la première couche de blindage électromagnétique,
former un pont de bord (150) pour couvrir une limite entre la première couche de blindage électromagnétique (120) et la couche isolante (130) et la périphérie de celle-ci sur une surface supérieure de la première couche de blindage électromagnétique (120) et une partie périphérique d'une surface supérieure de la couche isolante (130) ; et
former une deuxième couche de blindage électromagnétique (140) pour couvrir la surface supérieure de la couche isolante (130) et une surface supérieure du pont de bord (150),
dans lequel la première couche de blindage électromagnétique (120) recouvre une surface latérale de la couche isolante (130),
dans lequel le pont de bord (150) relie électriquement la première couche de blindage électromagnétique (120) et la deuxième couche de blindage électromagnétique (140) l'une à l'autre .

3. Procédé selon la revendication 2, dans lequel au moment de l'injection de la couche isolante (130), la première couche de blindage électromagnétique (120) comprend un matériau de blindage électromagnétique ayant une viscosité supérieure à une viscosité de la couche isolante (130).

[Fig. 1]

$\underline{100}$

[Fig. 2]

[Fig. 3A]

[Fig. 3B]

[Fig. 3C]

[Fig. 4A]

[Fig. 4B]

[Fig. 5]

[Fig. 6]

(a)

(b)

[Fig. 7]

[Fig. 8]

[Fig. 9]

[Fig. 10]

Z

Y

X

616

115

110

119

117

120

100a

[Fig. 11]

150a

115a  140a  130a

150a

120a

117a
120a

119a

114a
112a
110a

114a  112a

116a 111a

[Fig. 12]

[Fig. 13]

100c

[Fig. 14]

100d

[Fig. 15]

100e

[Fig. 16]

100g

115g  140g  141g  S

123g  117g
120g  120g
114g
112g
110g

114g  112g  116g 111g

[Fig. 17]

100h

150h  115h  140h  143h  S  150h

141h  141h
117h
120h  120h
114h
112h
110h

114h  112h  116h 111h

[Fig. 18A]

140h

141h

141h

[Fig. 18B]

[Fig. 19]

(a)

(b)

(c)

(d)

[Fig. 20]

100i

[Fig. 21A]

[Fig. 21B]

[Fig. 22]

100j

[Fig. 23]

100k

[Fig. 24]

[Fig. 25]

100l

[Fig. 26]

100n

[Fig. 27]

[Fig. 28]

[Fig. 29]

[Fig. 30]

**REFERENCES CITED IN THE DESCRIPTION**

**Patent documents cited in the description**

- US 7482686 A
- WO 0013233 A1
- US 5583378 A